# EUROPEAN PATENT APPLICATION

(11) **EP 4 590 082 A1**
(43) Date of publication of application: **23.07.2025**
(21) Application number: 23865089.9
(22) Date of filing: 25.07.2023
(51) Int. Cl.: H05K 9/00, G02B 7/02, G03B 15/00, G03B 17/02, G03B 30/00, H04N 23/50, H05K 5/00, H05K 5/04

(54) **ELECTRONIC DEVICE AND IMAGING APPARATUS**

(30) Priority: 15.09.2022 JP 2022147155
(71) Applicant: Sony Semiconductor Solutions Corporation, Atsugi-shi, Kanagawa 243-0014 (JP)
(72) Inventor: TOKITO, Toshihiro, Atsugi-shi, Kanagawa 243-0014 (JP); OWAKI, Hirofumi, Atsugi-shi, Kanagawa 243-0014 (JP); TANAKA, Haruki, Atsugi-shi, Kanagawa 243-0014 (JP)
(74) Representative: Witte, Weller & Partner Patentanwälte mbB
(86) International application number: PCT/JP2023/027100
(87) International publication number: WO 2024/057729

(57) **Abstract**

An electronic apparatus includes: a first chassis which is formed of a conductive material and includes a box portion that includes a first base portion, first side walls, and second side walls and accommodates a substrate unit, each of the first side walls and the second side walls being provided in the first base portion and opposing each other in any one of directions orthogonal to a first direction; a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surface of the first case pressing at least one of the first side walls or the second side walls in at least any one of the directions orthogonal to the first direction; and a second case which includes a second opening portion that is bonded to the first opening portion, and fixes the first chassis and a second chassis such that the first chassis and the second chassis are electrically connected in a state where the first opening portion and the second opening portion are bonded to each other in the first direction.

## Description

### Technical Field

The present disclosure relates to an image pickup apparatus and an electronic apparatus that can be mounted on a movable body such as a vehicle.

### Background Art

There is known an image pickup apparatus that can be mounted on a movable body such as a vehicle (Patent Literature 1). In an image pickup apparatus 20 of Patent Literature 1, a chassis structure that covers a lens-side substrate 14 is formed by sheet metals 22, 23, and 24. The sheet metals 22, 23, and 24 are integrated by welding, caulking, bonding, and the like, and are then integrated with a housing 16 formed of resin by insert molding. A rear-connector-side sheet metal 38 is assembled while being pressed against lens-side chassis 22, 23, and 24 with conductive rubber 39 interposed therebetween, and is thus electrically and conductively connected with the lens-side chassis 22, 23, and 24.

### Citation List

### Patent Literature

Patent Literature 1: Japanese Patent Application Laid-open No. 2020-177195

### Disclosure of Invention

### Technical Problem

In Patent Literature 1, the electrical connection by the conductive rubber 39 between the lens-side chassis constituted of three components, that is, the sheet metals 22, 23, and 24, and the sheet metal 38 as the rear-connector-side chassis is disadvantageous as compared to a simultaneous connection of the sheet metals from a viewpoint of EMC (Electromagnetic Compatibility). Further, since the lens-side chassis is constituted of the three components, that is, the sheet metals 22, 23, and 24 that further need to be integrated by welding, caulking, bonding, or the like, there is a fear that costs will increase. In addition, there is a fear that an internal space for accommodating the components will become small. The lens-side chassis constituted of the three components, that is, the sheet metals 22, 23, and 24 is insert-molded with respect to the housing 16 formed of resin. Therefore, there is a fear that component costs will increase due to facilities, manhours, management, and the like for the insert molding and that quality control will become difficult due to abrasion of resin and the like.

In view of the circumstances as described above, the present disclosure aims at electrically connecting, in an effective manner, a plurality of chassis for accommodating a substrate unit including electronic components, and maximizing an internal space for accommodating the components.

### Solution to Problem

An electronic apparatus according to an embodiment of the present disclosure includes:
a substrate unit including an electronic component;
a first chassis which is formed of a conductive material and includes a box portion that includes a first base portion, first side walls, and second side walls and accommodates the substrate unit, the first side walls and the second side walls being provided in the first base portion and opposing each other in any one of directions orthogonal to a first direction;
a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surfaces of the first case pressing at least one of the first side walls or the second side walls in at least any one of the directions orthogonal to the first direction;
a second chassis which is formed of a conductive material and includes a second base portion that opposes the substrate unit in the first direction; and
a second case which includes a second opening portion that is bonded to the first opening portion, and fixes the first chassis and the second chassis such that the first chassis and the second chassis are electrically connected in a state where the first opening portion and the second opening portion are bonded to each other in the first direction.

With this configuration, the first chassis and the second chassis can be electrically connected (GND-bonded) without using conductive rubber. This realizes excellent EMC and low costs since the number of components is small, and is advantageous in quality control since the number of manufacturing processes is small, as compared to the case of using conductive rubber. When the first chassis is accommodated in the first case, the first case and the first chassis relatively push each other and repel, and thus four surfaces of the first chassis can be electrically connected to one another.

The first case may have a tapered shape that widens from the bottom surface toward the first opening portion, and
when the first chassis is accommodated in the first case, the first side walls and the second side walls may widen from the first base portion along the tapered shape.

With this configuration, the first chassis closely adheres to a large portion of inner wall surfaces of the first case, and thus it is possible to take full advantage of the internal space of the first case and maximize the internal space for accommodating components as the box-type first chassis. In other words, since the first chassis and the first case each have a truncated square pyramid shape that spreads toward the bottom, spatial efficiency is higher than that in a right-angle-bent box structure. Further, the first case can stably retain the first chassis without a backlash so as to be capable of absorbing individual differences of each of the first case and the first chassis. In addition, since contact points can be secured without using burring caulking, spot welding, and the like, this contributes to simplification of component manufacturing processes and lowering of component costs.

The first side walls and the second side walls may be at least partially separated from each other when not accommodated in the first case.

The first side walls and the second side walls may be completely separated from each other when not accommodated in the first case, or when separated from each other when at least parts thereof may be in contact with each other, the electrical connection can be established by bringing them into contact with each other, or when at least parts thereof are in contact with each other, the electrical connection by the contact can be continued.

One of the first side walls or the second side walls may each include one or more convex portions that protrude while opposing in a direction in which the first side walls and the second side walls oppose each other.

By accommodating the first chassis in the first case, the box shape is obtained, and contact points by the convex portions are secured. By providing the convex portions, the convex portions are easily and certainly brought into contact with the side walls, a possibility of occurrence of a contact failure due to variations is reduced, and it becomes easy to establish mutual electrical connections for sure as compared to a case where surface contact is assumed to be made without providing the convex portions.

Another one of the first side walls or the second side walls may each include one or more receiving holes that engage with the one or more convex portions.

By engaging the convex portions with the receiving holes, the possibility of occurrence of a contact failure is reduced, and it becomes easy to establish mutual electrical connections for sure.

One of the first side walls or the second side walls may each include two or more convex portions that protrude while opposing in a direction in which the first side walls and the second side walls oppose each other and are arranged while being separated from each other in the first direction, and
the one or another one of the first side walls or the second side walls may each include one or more slit portions that are provided between the two or more convex portions in the first direction and extend in a direction containing a component of one direction orthogonal to the first direction.

When the first chassis is accommodated in the first case, portions at which the convex portions are provided are sectioned by the slit portions and can each be deformed (bow or the like) independently. The two convex portions can independently follow a contacting surface so as to certainly come into contact therewith, with the result that the electrical contact is secured. In other words, by accommodating the first chassis in the first case, the box shape is obtained, and the contact points by the convex portions are secured.

The first chassis may include a pair of first contact members and a pair of second contact members that are provided in the box portion,
the first case may accommodate the first chassis such that the pair of first contact members and the pair of second contact members are exposed from the first opening portion,
the second chassis may include a pair of third contact members and a pair of fourth contact members that are provided in the base portion, and
the second case may fix the first chassis and the second chassis such that, in the state where the first opening portion and the second opening portion are bonded to each other in the first direction, the pair of first contact members and the pair of third contact members are electrically connected at two or more first contact points and the pair of second contact members and the pair of fourth contact members are electrically connected at two or more second contact points.

With this configuration, the first chassis and the second chassis can be electrically connected (GND-bonded) without using conductive rubber. This realizes excellent EMC and low costs since the number of components is small, and is advantageous in quality control since the number of manufacturing processes is small, as compared to the case of using conductive rubber.

The third contact members of the second chassis may be capable of bowing in a second direction orthogonal to the first direction, and
in the state where the first opening portion of the first case and the second opening portion of the second case are bonded to each other in the first direction, the second case may press the third contact members of the second chassis against the first contact members of the first chassis in the second direction so that the first contact members and the third contact members are electrically connected at the first contact points.

By pressing the third contact members of the second chassis against the first contact members of the first chassis in an X direction, the first contact members and the third contact members can be electrically connected for sure at the first contact points.

The third contact members of the second chassis may be capable of opening and closing in the second direction by bowing in the second direction,
the second case may press the third contact members of the second chassis in the second direction to close the third contact members, and
the first contact members and the third contact members may be electrically connected at the first contact points by inserting the first contact members of the first chassis into the third contact members closed by the second case in the first direction so that the third contact members bow in the second direction to nip the first contact members in the second direction.

When inserting the first contact members of the first chassis, the first contact members come into contact with the openable/closable third contact members, so the first contact members can certainly be inserted into the third contact members. Also, after the insertion, the first contact members are electrically connected (GND-bonded) to the openable/closable third contact members for sure.

When the first chassis and the second chassis are fixed by the second case, a thickness of a to-be-nipped portion of each of the first contact members that is a portion to be nipped by the third contact member, in the second direction may be larger than a thickness of a non-contact portion of each of the first contact members that is a portion not in contact with the third contact member, in the second direction.

By the third contact members bowing in the X direction and nipping the to-be-nipped portion of the first contact members having a large thickness, the first contact members and the third contact members can be electrically connected at the first contact points for sure.

The fourth contact members of the second chassis may be capable of bowing in the first direction, and
in the state where the first opening portion of the first case and the second opening portion of the second case are bonded to each other in the first direction, the second contact members of the first chassis and the fourth contact members of the second chassis may relatively push each other in the first direction so that the second contact members and the fourth contact members may be electrically connected at the second contact points.

Therefore, the two second contact members of the first chassis and the fourth contact members of the second chassis are stably electrically connected (GND-bonded) for sure.

The second contact members of the first chassis may each protrude from a first fulcrum point provided in the box portion in a direction containing a component of a third direction orthogonal to the first direction,
the fourth contact members of the second chassis may each protrude from second fulcrum points provided in the second base portion in the direction containing the component of the third direction,
a length of the fourth contact members of the second chassis in the third direction may be larger than a length of the second contact members of the first chassis in the third direction,
the second fulcrum points of the second chassis may be positioned more on an inner side of the electronic apparatus in the third direction than the first fulcrum point of the first chassis,
the second contact members of the first chassis may be tilted toward the fourth contact members of the second chassis, and
at the second contact points, a tilt angle of the second contact members of the first chassis with respect to the third direction may be larger than a tilt angle of the fourth contact members of the second chassis with respect to the third direction.

Therefore, the fourth contact members of the second chassis are pushed downwardly to bow. However, no unreasonable stress is generated in a cantilever-type leaf spring structure of the fourth contact members, and thus the second contact members of the first chassis and the fourth contact members of the second chassis are stably electrically connected (GND-bonded) for sure.

The fourth contact members of the second chassis may include a space portion penetrating in the first direction between the second fulcrum points and the second contact points.

By the structure in which the space portion is provided on the inner side of each of the fourth contact members, the fourth contact members each form a leaf spring structure that can bow flexibly. Therefore, the fourth contact members of the second chassis bow more easily than the second contact members of the first chassis. Conversely, the second contact members of the first chassis are more robust than the fourth contact members of the second chassis. Therefore, the fourth contact members of the second chassis are pushed downwardly to bow. However, no unreasonable stress is generated in the cantilever-type leaf spring structure of the fourth contact members, and thus the second contact members of the first chassis and the fourth contact members of the second chassis are stably electrically connected (GND-bonded) for sure.

Two or more of the second contact members may be electrically connected with respect to one of the fourth contact members at the second contact points.

With this configuration, the first chassis and the second chassis are GND-connected at a total of six or more positions including two or more first contact points and four or more second contact points, thus being advantageous from the viewpoint of EMC since a span of an electrically-unconnected state becomes short. Moreover, since the first chassis and the second chassis are GND-connected at the total of six or more positions, a gap between the first chassis and the second chassis is minimized, thus being advantageous from the viewpoint of EMC. In addition, the first chassis and the second chassis are GND-connected at the total of six or more positions. Thus, heat can be efficiently transmitted to the second chassis via the first chassis, and heat of a built-in device that generates heat can be efficiently released to the first case and the second case as outer housings of an image pickup apparatus 2 via the first chassis and the second chassis.

The fourth contact members of the second chassis may be capable of bowing in a third direction orthogonal to the first direction, and
in the state where the first opening portion of the first case and the second opening portion of the second case are bonded to each other in the first direction, the second contact members of the first chassis and the fourth contact members of the second chassis may relatively push each other in the third direction so that the second contact members and the fourth contact members may be electrically connected at the second contact points.

Therefore, the first chassis and the second chassis are stably electrically connected (GND-bonded) for sure.

The two or more first contact points and the two or more second contact points may be arranged at positions corresponding to four sides of a rectangle when seen in the first direction.

With this configuration, since the first chassis and the second chassis can be electrically connected at many points substantially equally in a circumferential direction, it is advantageous from the viewpoint of EMC since the span of an electrically-unconnected state becomes short.

The first chassis may be formed of a metal material as the conductive material,
the second chassis may be formed of a metal material as the conductive material, and
the electrical connection between the first chassis and the second chassis does not need to include an electrical connection by members other than the first chassis and the second chassis, that are formed of a conductive material.

This realizes excellent EMC and low costs since the number of components is small, and is advantageous in quality control since the number of manufacturing processes is small, as compared to the case of using conductive rubber.

The electronic component may include an imager device, and
the electronic apparatus may further include a lens block which includes a lens retained in the first case or the second case and is optically connected to the imager device while the first direction is set as an optical axis direction.

This realizes excellent EMC and low costs since the number of components is small, and is advantageous in quality control since the number of manufacturing processes is small, as compared to the case of using conductive rubber in the image pickup apparatus.

An image pickup apparatus according to an embodiment of the present disclosure includes:
a substrate unit including an electronic component including an imager device;
a first chassis which is formed of a conductive material and includes a box portion that includes a first base portion, first side walls, and second side walls and accommodates the substrate unit, the first side walls and the second side walls being provided in the first base portion and opposing each other in any one of directions orthogonal to a first direction;
a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surfaces of the first case pressing at least one of the first side walls or the second side walls in at least any one of the directions orthogonal to the first direction;
a second chassis which is formed of a conductive material and includes a second base portion that opposes the substrate unit in the first direction;
a second case which includes a second opening portion that is bonded to the first opening portion, and fixes the first chassis and the second chassis such that the first chassis and the second chassis are electrically connected in a state where the first opening portion and the second opening portion are bonded to each other in the first direction; and
a lens unit which is retained in the first case or the second case and is optically connected to the imager device while the first direction is set as an optical axis direction.

### Brief Description of Drawings

[FIG. 1] A cross-sectional view illustrating an image pickup apparatus according to an embodiment of the present disclosure.
[FIG. 2] An exploded perspective view illustrating the image pickup apparatus.
[FIG. 3] A perspective view illustrating a front chassis.
[FIG. 4] A side view of the front chassis seen in a Y direction.
[FIG. 5] A perspective view illustrating a state where the front chassis is attached to a front case of a lens block (dustproof sheet is not illustrated).
[FIG. 6] A diagram schematically illustrating the state where the front chassis is attached to the front case of the lens block (dustproof sheet is not illustrated).
[FIG. 7] A side view of the front chassis in the state shown in FIG. 6 seen in the Y direction.
[FIG. 8] A perspective view illustrating a rear chassis before being attached to a rear case.
[FIG. 9] A side view of the rear chassis before being attached to the rear case, seen in the Y direction.
[FIG. 10] A side view of the rear chassis before being attached to the rear case, seen in an X direction.
[FIG. 11] A perspective view illustrating a state where the rear chassis is attached to the rear case.
[FIG. 12] A cross-sectional view illustrating the state where the rear chassis is attached to the rear case.
[FIG. 13] A perspective view illustrating the rear chassis in the state shown in FIG. 11.
[FIG. 14] A side view of the rear chassis in the state shown in FIG. 11, seen in the Y direction.
[FIG. 15] A side view of the rear chassis in the state shown in FIG. 11, seen in the X direction.
[FIG. 16] A perspective view illustrating a state after the rear chassis attached to the rear case (not shown) is attached to the front chassis attached to the front case (not shown).
[FIG. 17] A perspective view illustrating the state after the rear chassis attached to the rear case (not shown) is attached to the front chassis attached to the front case (not shown).
[FIG. 18] A side view illustrating a state before the rear chassis attached to the rear case (not shown) is attached to the front chassis attached to the front case (not shown), the side view seen in the Y direction.
[FIG. 19] A side view illustrating the state after the rear chassis attached to the rear case (not shown) is attached to the front chassis attached to the front case (not shown), the side view seen in the Y direction.
[FIG. 20] A side view illustrating the state before the rear chassis attached to the rear case (not shown) is attached to the front chassis attached to the front case (not shown) (the state shown in FIG. 18), the side view seen in the X direction.
[FIG. 21] A side view illustrating the state after the rear chassis attached to the rear case (not shown) is attached to the front chassis attached to the front case (not shown) (the state shown in FIG. 19), the side view seen in the X direction.
[FIG. 22] A partial perspective view illustrating a rear chassis according to a modified example.
[FIG. 23] A partial perspective view illustrating a rear chassis according to another modified example.
[FIG. 24] A perspective view illustrating a rear chassis and a front chassis according to a modified example.
[FIG. 25] A diagram schematically illustrating the rear chassis and the front chassis attached to the front case.
[FIG. 26] A perspective view illustrating a rear chassis and a front chassis according to another modified example.
[FIG. 27] A partial perspective view illustrating the rear chassis and the front chassis before being attached.
[FIG. 28] A partial perspective view illustrating the rear chassis and the front chassis after being attached.
[FIG. 29] A partial side view of the rear chassis and the front chassis after being attached, the view seen in the Y direction.
[FIG. 30] A block diagram illustrating a configuration example of a vehicle control system.
[FIG. 31] A diagram illustrating an example of sensing areas.

### Modes for Carrying Out the Invention

Hereinafter, an embodiment of the present disclosure will be described with reference to the drawings. An electronic apparatus according to the present embodiment will be described as an image pickup apparatus which is mounted on a movable body such as a vehicle.

### 1. Image pickup apparatus

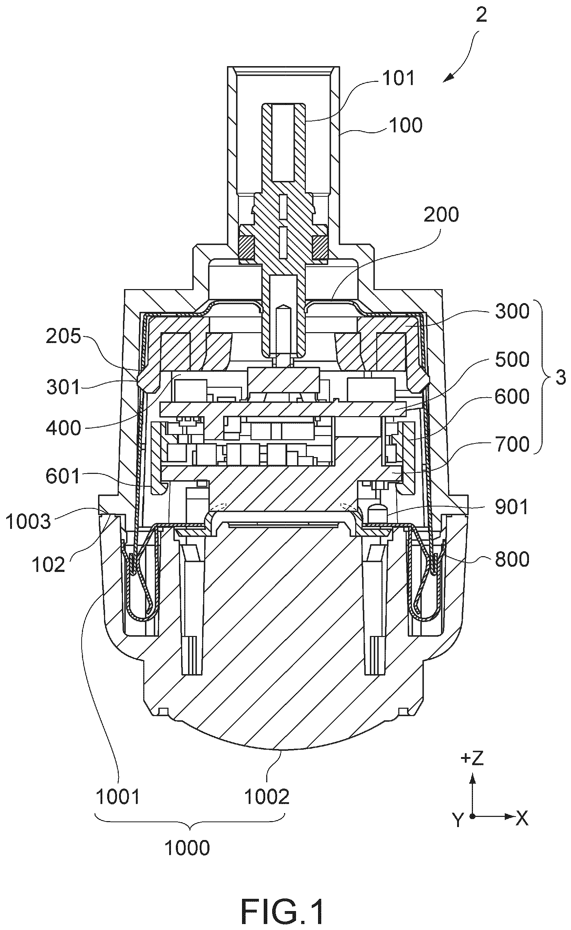

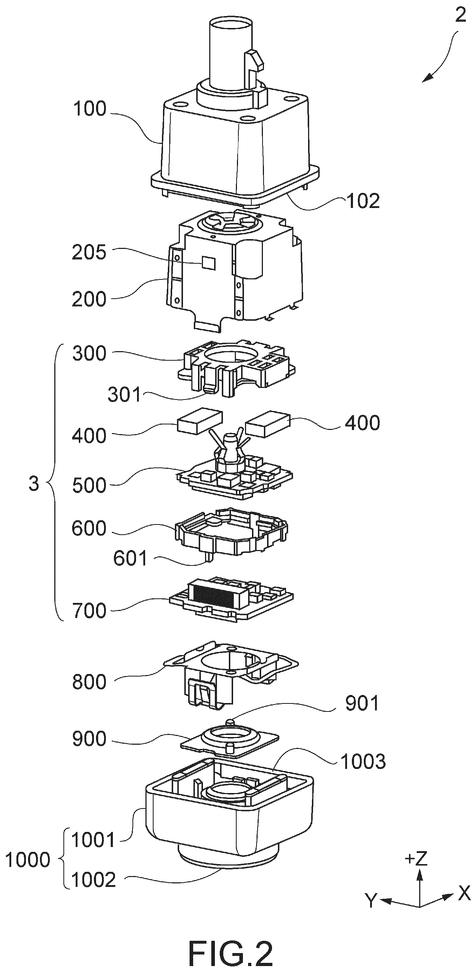

FIG. 1 is a cross-sectional view illustrating an image pickup apparatus according to an embodiment of the present disclosure. FIG. 2 is an exploded perspective view illustrating the image pickup apparatus.

The image pickup apparatus 2 is mounted on, for example, a movable body such as a vehicle. The image pickup apparatus 2 includes a rear case 100 (first case), a rear chassis 200 (first chassis), a substrate unit 3, a front chassis 800 (second chassis), a dustproof sheet 900, and a lens block 1000. The lens block 1000 includes a front case 1001 (second case) and a lens 1002. The substrate unit 3 includes a radiation block 300, a radiation sheet 400, a connector substrate 500, a substrate holder 600, and an imager substrate 700, and also includes electronic components mounted on the connector substrate 500 and the imager substrate 700.

The rear case 100 (first case) is a rear case formed of a resin material such as a nylon resin, polyamide, polystyrene, an ABS resin, and a PMMA resin, and a coaxial connector 101 is press-fitted therein.

The coaxial connector 101 includes a shell formed of brass die cast or a copper alloy and a terminal formed of brass or a copper alloy.

The rear chassis 200 (first chassis) is a chassis on the rear case 100 side. The rear chassis 200 is formed of a conductive material and is, specifically, a sheet metal formed of a copper-based, stainless steel-based, or aluminum-based metal material, or the like.

The radiation block 300 is formed of a material having a relatively high heat conductivity, such as a polycarbonate resin, an ABS resin, and a PBT resin.

The radiation sheet 400 has shape followability and elasticity, is formed of a material having a relatively high heat conductivity, and is, for example, a silicon rubber sheet material, a radiation gel material, radiation grease, or the like.

The substrate holder 600 is formed of a resin material such as a polycarbonate resin, an ABS resin, and a PBT resin and retains the connector substrate 500 and the imager substrate 700.

The imager substrate 700 includes an imager device as the electronic component. The imager device is, for example, a CCD (Charge Coupled Device) image sensor or a CMOS (Complementary Metal Oxide Semiconductor) image sensor, and picks up an optical image formed on a light-receiving surface to generate image signals. The imager substrate 700 is a glass epoxy multilayer substrate, a Teflon^{®} (the same applies hereinafter) multilayer substrate, or the like.

The front case 1001 (second case) of the lens block 1000 is a front case formed of a resin material such as a nylon resin, polyamide, polystyrene, an ABS resin, and a PMMA resin. The lens 1002 of the lens block 1000 is retained in the front case 1001 and is formed of, for example, glass or plastic.

The front chassis 800 (second chassis) is a chassis on the front case 1001 side. The front chassis 800 is formed of a conductive material and is, specifically, a sheet metal formed of a copper-based, stainless steel-based, or aluminum-based metal material, or the like.

The dustproof sheet 900 is a molded component formed of silicon rubber or urethane rubber and prevents dusts from entering the lens block 1000.

The connector substrate 500 optically connects the coaxial connector 101, the imager device of the imager substrate 700, and the lens 1002 of the lens block 1000. The connector substrate 500 is a glass epoxy multilayer substrate, a Teflon multilayer substrate, or the like.

In descriptions hereinafter, an optical axis direction will be referred to as a Z direction (first direction), one direction orthogonal to the Z direction will be referred to as an X direction (second direction), and one direction orthogonal to the Z direction and the X direction will be referred to as a Y direction (third direction). Of the Z direction, particularly a direction directed from the front case 1001 toward the rear case 100 (i.e., from the lens 1002 toward the coaxial connector 101) (a direction directed from the bottom toward the top in FIG. 1) will be referred to as a +Z direction. Conversely, a direction directed from the rear case 100 toward the front case 1001 (i.e., from the coaxial connector 101 toward the lens 1002) (a direction directed from the top toward the bottom in FIG. 1) will be referred to as a -Z direction. The image pickup apparatus 2 has a rectangular shape when seen in the Z direction, specifically, a rectangular shape that has four sides in the X direction and the Y direction orthogonal to each other. Hereinafter, the rectangular shape does not strictly refer to the rectangle alone and includes a shape that is close to a rectangle as a whole, that is, a planar shape that includes four sides that may form right angles in at least one portion thereof. Further, the rectangle includes a quadrate, and the rectangular shape includes a quadrate shape. Similarly, a rectangular parallelepiped shape does not strictly refer to a rectangular parallelepiped alone and includes a shape that is close to the rectangular parallelepiped as a whole, that is, a 3-dimensional shape that includes six sides that may form right angles in at least one portion thereof. Further, the rectangular parallelepiped includes a cube, and the rectangular parallelepiped shape includes a cubic shape. Similarly, a truncated square pyramid shape does not strictly refer to a truncated square pyramid alone and includes a shape that is close to the truncated square pyramid as a whole. In the drawings, hatching may be omitted for viewability in cross-sectional views.

The front chassis 800 is pushed into and temporarily fixed to the front case 1001 of the lens block 1000 with the dustproof sheet 900 interposed therebetween. The substrate holder 600 is retained in the imager substrate 700 via left and right claw portions 601, 601. The imager substrate 700 and the connector substrate 500 are coupled by connectors respectively mounted thereon. The imager substrate 700 is bonded and fixed to the lens block 1000 at a position at which the imager device thereof is optically adjusted with respect to the lens 1002 of the lens block 1000. The rear chassis 200 is pushed into and fixed to the rear case 100. By fitting left and right claw portions 301, 301 to hole portions 205, 205 of the rear chassis 200, the radiation block 300 is retained in the rear chassis 200 inserted into the rear case 100. The coaxial connector 101 is incorporated into the rear case 100 as a built-in component. An optical system including the lens 1002 is incorporated into the front case 1001, to thus constitute the lens block 1000. A rear case opening portion 102 (first opening portion) of the rear case 100 and a front case opening portion 1003 (second opening portion) of the front case 1001 are bonded in the Z direction and are welded to be fixed to each other at bonding surfaces thereof.

### 2. Front chassis (second chassis)

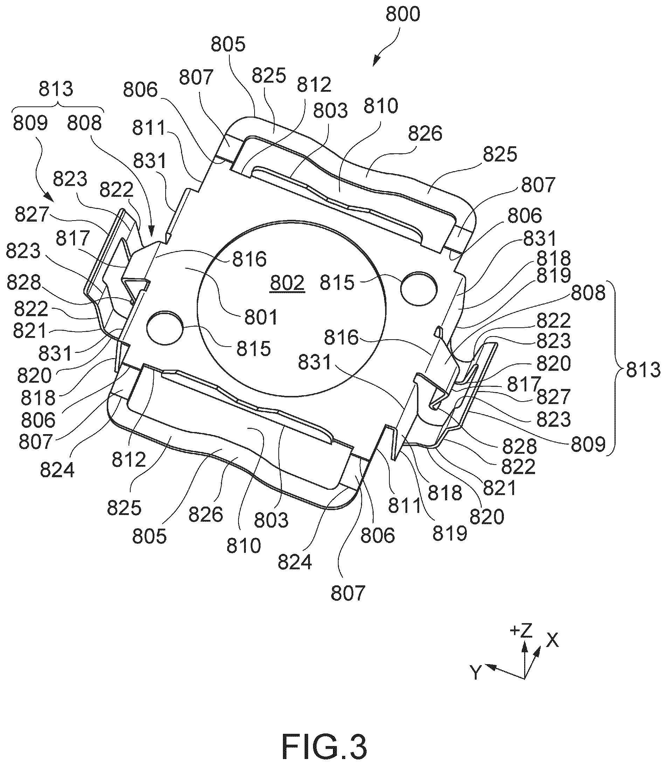

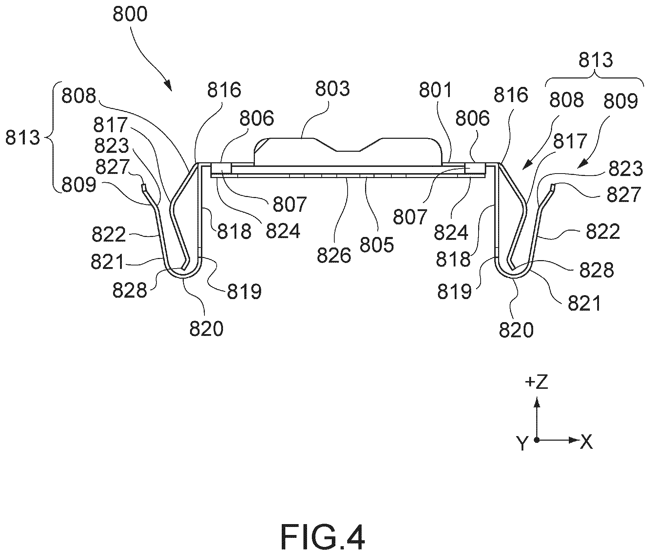

FIG. 3 is a perspective view illustrating the front chassis. FIG. 4 is a side view of the front chassis seen in the Y direction.

The front chassis 800 is formed by bending one sheet metal. The front chassis 800 includes a front chassis base portion 801 (second base portion). The front chassis base portion 801 has a rectangular shape having a pair of Y sides 811, 811 extending in the Y direction and a pair of X sides 812, 812 extending in the X direction. At a center portion of the front chassis base portion 801, an area 802 for taking in image light from the lens 1002 is provided. Through-holes 815, 815 are further provided in the front chassis base portion 801. Positioning convex portions 901, 901 of the dustproof sheet 900 are inserted into the through-holes 815, 815 (FIGS. 1 and 2), and the through-holes 815, 815 are used for positioning the front chassis 800 and the dustproof sheet 900.

Catch-type contact members 813 (third contact members) are respectively provided at the Y sides 811 of the front chassis base portion 801. The catch-type contact members 813 are openable and closable in the X direction by bowing in the X direction. Specifically, the catch-type contact members 813 each include a first leaf spring 808 and a second leaf spring 809. The first leaf spring 808 and the second leaf spring 809 are not in contact with each other and are each capable of opening and closing in the X direction by bowing in the X direction.

The first leaf spring 808 protrudes, in a form of a cantilever, from a fulcrum point 816 including the center of the Y side 811 in a direction containing components of the X direction and the -Z direction, and is mountain-bent at a first leaf spring contact point 817. The first leaf spring contact point 817 which is an apex of the mountain protrudes in a direction in which a distance thereof from the front chassis base portion 801 increases in the X direction. With this structure, the first leaf spring 808 can bow from the fulcrum point 816 in the X direction.

The second leaf spring 809 includes a pair of wall portions 818, 818 that respectively protrude (are bent) in the -Z direction from a pair of bent portions 831, 831 on the Y side 811 that are provided to have spaces in the Y direction with respect to the first leaf spring 808. U-shaped portions 820 that each curve in a U shape in the direction containing the components of the X direction and the -Z direction are formed continuously from end portions 819 of the respective wall portions 818 in the -Z direction. A width of each of the U-shaped portions 820 in the Y direction is smaller than a width of each of the wall portions 818 in the Y direction. Therefore, the U-shaped portions 820 have higher elasticity than the wall portions 818. A tip end 828 of the first leaf spring 808 in the -Z direction is positioned in a space between the U-shaped portions 820 of the second leaf spring 809. When seen in the Y direction (FIG. 4), the tip end 828 of the first leaf spring 808 in the -Z direction opposes the U-shaped portions 820 of the second leaf spring 809 while spaces are provided in the X direction and the Z direction. Arm portions 822 that extend in a direction in which distances thereof from the front chassis base portion 801 increase in the X direction and the +Z direction are respectively provided at end points 821 of the U shapes of the U-shaped portions 820. The arm portions 822 are mountain-bent at second leaf spring contact points 823. The second leaf spring contact points 823 that are each an apex of the mountain face the front chassis base portion 801 in the X direction. When seen in the Y direction (FIG. 4), the second leaf spring contact points 823 oppose the first leaf spring contact point 817 of the first leaf spring 808 while a space is provided in the X direction (i.e., substantially at the same height in the Z direction). The pair of second leaf spring contact points 823, 823 are separated from each other in the Y direction and are not in contact with each other. Tip ends of the pair of arm portions 822, 822 in the +Z direction are continuous via a first longitudinal portion 827 extending in the Y direction. With this structure, the second leaf spring 809 can bow in the X direction while using the end portions 819, 819 of the pair of wall portions 818, 818 in the -Z direction as fulcrums.

A positioning piece 803 and a leaf-spring-type contact member 805 (fourth contact member) are provided on each of the X sides 812 of the front chassis base portion 801.

The positioning pieces 803 are each provided in an area including the center of the X side 812 and are erected in the +Z direction. The positioning pieces 803 are used for positioning when attaching the front chassis 800 to the front case 1001 of the lens block 1000.

The leaf-spring-type contact members 805 are capable of bowing in the Z direction. The leaf-spring-type contact member 805 of the front chassis 800 protrudes from a pair of second fulcrum points 806, 806 provided in the front chassis base portion 801 in the direction containing the components of the Y direction and the -Z direction. The pair of second fulcrum points 806, 806 are positioned on the X side 812 with spaces provided in the X direction with respect to the positioning piece 803. Specifically, the leaf-spring-type contact member 805 includes a pair of arm portions 807, 807 that protrude (are bent) in a form of cantilevers from the pair of second fulcrum points 806, 806 in the direction containing the components of the Y direction and the -Z direction. In other words, the arm portions 807 are tilted in the Y direction. Tip ends 824, 824 of the pair of arm portions 807, 807 in the -Z direction are continuous via a second longitudinal portion 825 that is parallel to the XY plane and extends in the X direction. The second longitudinal portion 825 and the front chassis base portion 801 are positioned apart from each other in the Z direction and are parallel to the XY plane. With this structure, the arm portions 807 constitute a Z-bending structure that is bent at the second fulcrum points 806 and the tip ends 824. While both end portions of the second longitudinal portion 825 in the X direction extend linearly in the X direction, a center portion 826 in the X direction is curved (meandered) on the XY plane toward the X side 812 of the front chassis base portion 801. By the X side 812 of the front chassis base portion 801, the second longitudinal portion 825, and the pair of arm portions 807, 807, a slit-like space portion 810 elongated in the X direction is provided on the inner side of the leaf-spring-type contact member 805 when seen on the XY plane. The space portion 810 penetrates in the Z direction. With this structure, the leaf-spring-type contact members 805 each constitute a leaf spring structure that can bow in the Z direction while using the pair of second fulcrum points 806, 806 as fulcrums. The space portion 810 is used for positioning the front chassis 800 and the front case 1001. The second longitudinal portion 825 constitutes a second contact point (to be described later).

### 3. Connection between front chassis (second chassis) and front case (second case)

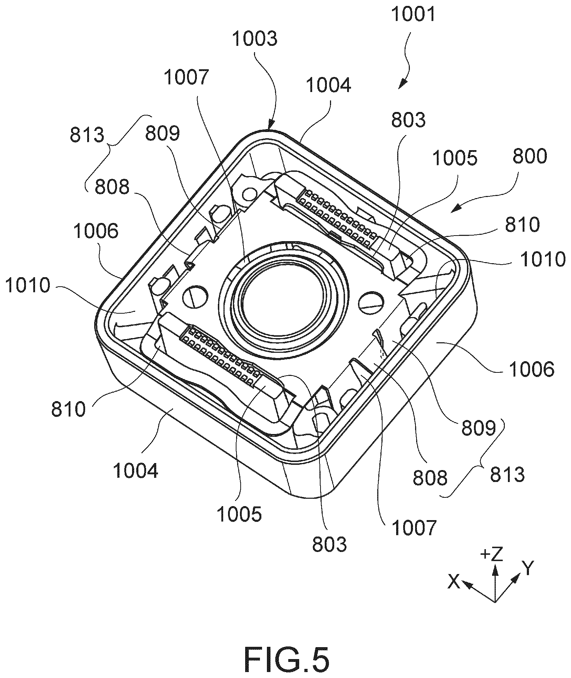

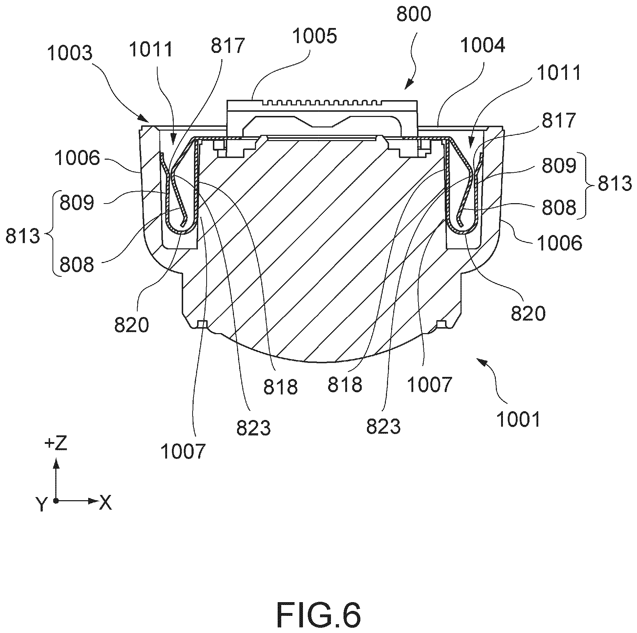

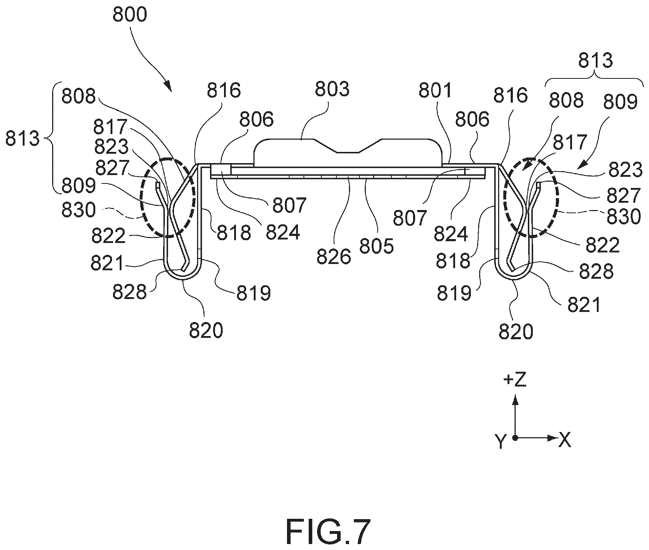

FIG. 5 is a perspective view illustrating a state where the front chassis is attached to the front case of the lens block (dustproof sheet is not illustrated). FIG. 6 schematically illustrates the state where the front chassis is attached to the front case of the lens block (dustproof sheet is not illustrated). FIG. 7 is a side view of the front chassis in the state shown in FIG. 6 seen in the Y direction.

The front case 1001 includes a pair of X side walls 1004, 1004 that extend in the X direction and each have a height in the Z direction and a pair of Y side walls 1006, 1006 that extend in the Y direction and each have a height in the Z direction. At least a part of the front case 1001 is of a rectangular parallelepiped shape. The front case opening portion 1003 of the front case 1001 faces the +Z direction. The front case 1001 includes a pair of X positioning convex portions 1005, 1005 and a pair of Y positioning convex portions 1007, 1007 inside the front case opening portion 1003.

When the front case 1001 is seen from the front case opening portion 1003 side in the -Z direction (FIG. 5), the pair of X positioning convex portions 1005, 1005 are provided while being apart from the pair of X side walls 1004, 1004, respectively. The X positioning convex portions 1005 each have a longitudinal side in the X direction and protrude in the +Z direction. The X positioning convex portions 1005 are each inserted into the space portion 810 of the front chassis 800. The X positioning convex portion 1005 is provided at a position at which the X positioning convex portion 1005 comes into contact with the positioning piece 803 when the X positioning convex portion 1005 is inserted into the space portion 810 of the front chassis 800. Thus, the front chassis 800 is positioned with respect to the front case 1001.

When the front case 1001 is seen from the front case opening portion 1003 side in the -Z direction (FIG. 5), the pair of Y positioning convex portions 1007, 1007 are provided while being apart from the pair of Y side walls 1006, 1006, respectively, in the X direction. The Y positioning convex portions 1007 each have a longitudinal side in the Y direction and protrude in the +Z direction. The catch-type contact member 813 (i.e., the first leaf spring 808 and the second leaf spring 809) of the front chassis 800 is pushed into a space 1011 between the Y positioning convex portion 1007 and the Y side wall 1006 in the -Z direction. Specifically, the U-shaped portions 820 of the second leaf spring 809 are pushed into the space 1011 between the Y positioning convex portion 1007 and the Y side wall 1006 in the -Z direction. Inner surfaces of the wall portions 818 of the second leaf spring 809 of the front chassis 800 come into contact with an opposing surface of the Y positioning convex portion 1007 opposing the Y side wall 1006. A width of the space 1011 between the Y positioning convex portion 1007 and the Y side wall 1006 in the X direction is slightly larger than the width of the first leaf spring 808 in the X direction and smaller than the width of the second leaf spring 809 in the X direction. Therefore, the arm portions 822 of the second leaf spring 809 are pressed in the X direction from an inner surface 1010 of the Y side wall 1006 of the front case 1001 so as to be deformed to be narrowed, and repel in a direction in which the arm portions 822 open in the X direction. In this manner, the Y positioning convex portion 1007 and the Y side wall 1006 of the front case 1001 press the catch-type contact member 813 of the front chassis 800 in the X direction, to thus close the catch-type contact members 813. When the front chassis 800 is attached to the front case 1001, the front chassis 800 is seen in the Y direction (FIG. 7). At this time, the second leaf spring contact points 823 of the second leaf spring 809 and the first leaf spring contact point 817 of the first leaf spring 808 come close to each other in the X direction to constitute a V-shaped catch structure 830. In the V-shaped catch structure 830, the first leaf spring 808 is not deformed and has its own elasticity. On the other hand, the second leaf spring 809 receives a pressing force directed toward an inner side of the X direction from the inner surface 1010 of the Y side wall 1006 of the front case 1001, and thus has a repulsion in the X direction, that is directed toward the Y side wall 1006 of the front case 1001.

### 4. Rear chassis (first chassis)

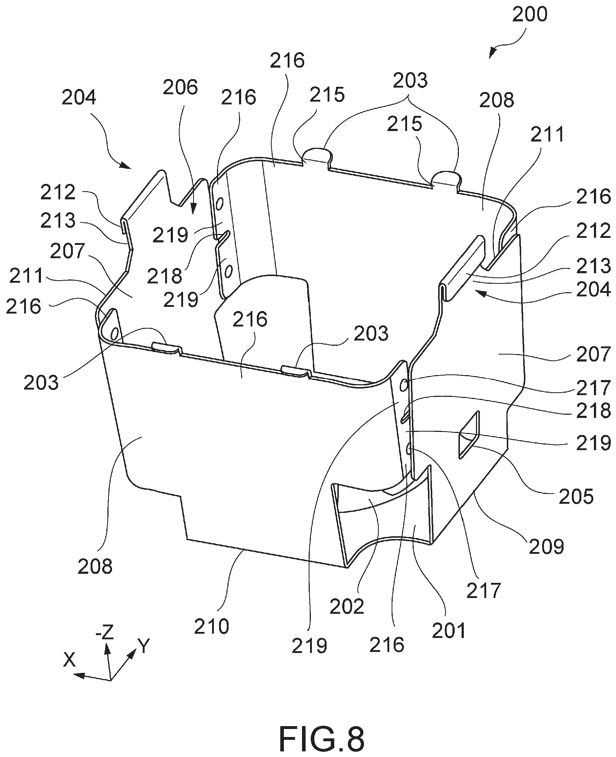

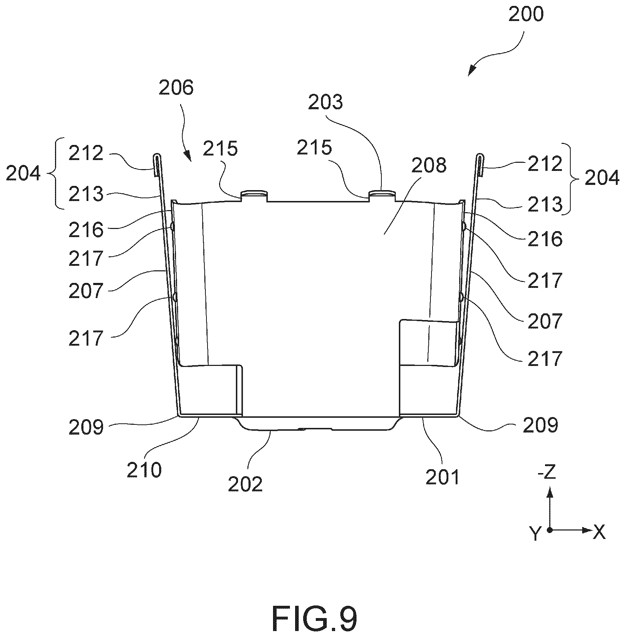

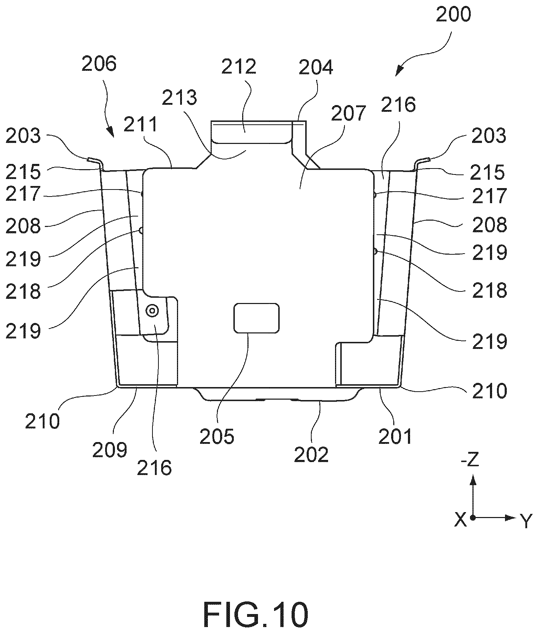

FIG. 8 is a perspective view illustrating the rear chassis before being attached to the rear case. FIG. 9 is a side view of the rear chassis before being attached to the rear case, seen in the Y direction. FIG. 10 is a side view of the rear chassis before being attached to the rear case, seen in the X direction.

The rear chassis 200 is formed by bending one sheet metal. The rear chassis 200 includes a box portion 206 which accommodates the substrate unit 3 and a pair of to-be-nipped-type contact members 204 (first contact members) and a pair of pressing-type contact members 203 (second contact members) that are provided in the box portion 206. The box portion 206 includes a rear chassis base portion 201 (first base portion) and a pair of Y side walls 207, 207 and a pair of X side walls 208, 208 that are provided in the rear chassis base portion 201. A fitting portion 202 constituted of four burring shapes is arranged at a center of the rear chassis base portion 201 and is coupled to a connector terminal of the rear case 100.

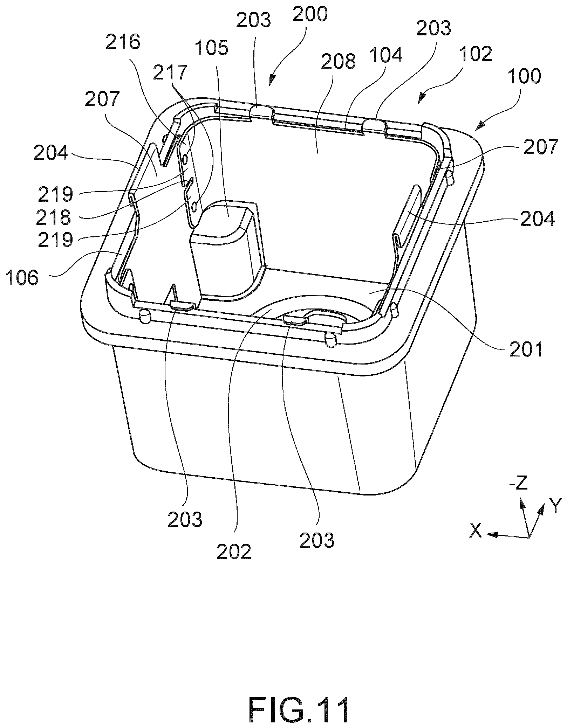

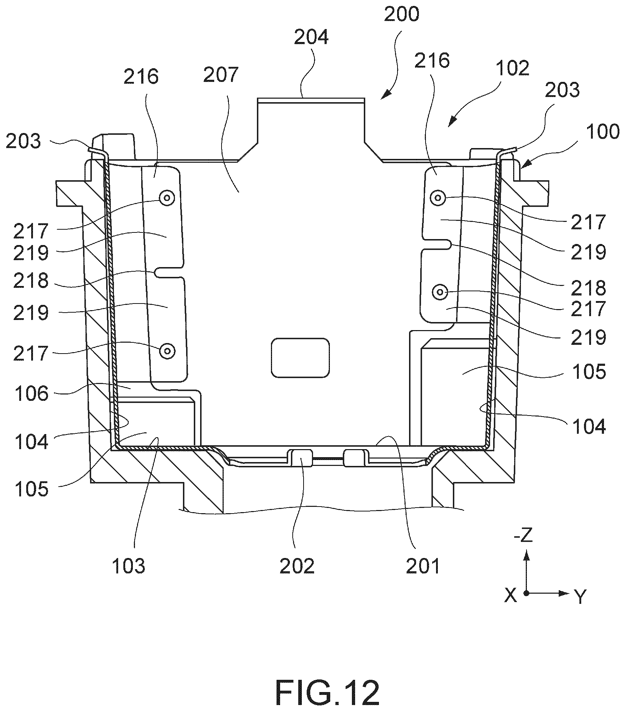

The rear chassis base portion 201 opposes a bottom surface 103 of the rear case 100 in the Z direction when accommodated in the rear case 100. The rear chassis base portion 201 has a rectangular shape including a pair of Y sides 209, 209 extending in the Y direction and a pair of X sides 210, 210 extending in the X direction. When the rear chassis base portion 201 is seen on the XY plane, four corners of the rectangle are notched, but this depends on convex portions 105 formed inside the rear case 100 into which the rear chassis 200 is to be inserted (FIGS. 11 and 12).

The Y side wall 207 is formed by bending the Y side 209 of the rear chassis base portion 201. The Y side walls 207 do not form right angles with respect to the rear chassis base portion 201 and widen from the rear chassis base portion 201 in the direction containing the components of the X direction and the -Z direction (FIG. 9). The to-be-nipped-type contact member 204 protruding in the -Z direction is provided at a Y end portion 211 that is an end portion of the Y side wall 207 in the -Z direction. The to-be-nipped-type contact member 204 includes a to-be-nipped portion 212 and a non-contact portion 213. The to-be-nipped portion 212 is a portion to be nipped by the catch-type contact member 813 when the rear chassis 200 and the front chassis 800 are fixed by the front case 1001. The non-contact portion 213 is a portion not in contact with the catch-type contact member 813. A thickness of the to-be-nipped portion 212 in the X direction is larger than a thickness of the non-contact portion 213 in the X direction. For example, the to-be-nipped portion 212 is folded 180 degrees in the Z direction so that the thickness thereof in the X direction becomes twice the thickness of the non-contact portion 213.

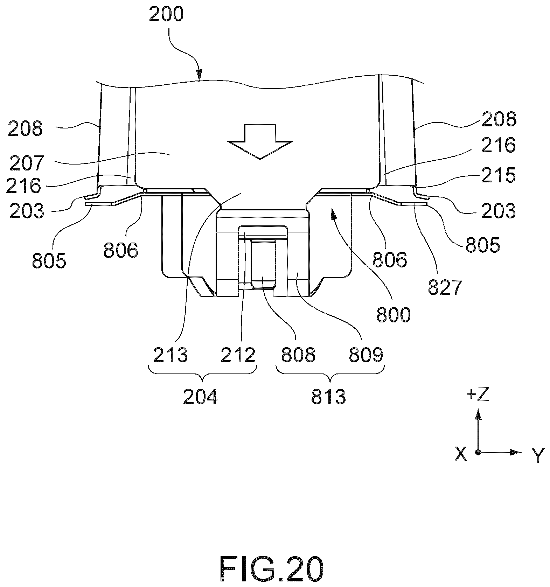

The X side wall 208 is formed by bending the X side 210 of the rear chassis base portion 201. The X side walls 208 do not form right angles with respect to the rear chassis base portion 201 and widen from the rear chassis base portion 201 in the direction containing the components of the Y direction and the -Z direction (FIG. 10). Two or more (two in the present example) pressing-type contact members 203, 203 are provided at an X end portion 216 that is an end portion of the X side wall 208 in the -Z direction. In other words, since the pressing-type contact members 203, 203 are provided two each to each of the pair of X end portions 216, 216, the rear chassis 200 includes a total of four pressing-type contact members 203. At the X end portion 216, the two pressing-type contact members 203, 203 are provided at positions apart from each other in the X direction. The pressing-type contact members 203 each protrude from a first fulcrum point 215 provided at the X end portion 216 of the X side wall 208 in the direction containing the components of the Y direction and the -Z direction. In other words, the pressing-type contact members 203 are tilted in the Y direction. A tilt angle of the pressing-type contact members 203 of the rear chassis 200 with respect to the Y direction and the -Z direction is larger than a tilt angle of the arm portions 807 of the leaf-spring-type contact members 805 of the front chassis 800 with respect to the Y direction and the -Z direction (FIG. 20).

The Y side walls 207 widen from the rear chassis base portion 201 in the X direction (FIG. 9), and the X side walls 208 widen from the rear chassis base portion 201 in the Y direction (FIG. 10). In other words, when not accommodated in the rear case 100, at least a part of the box portion 206 of the rear chassis 200 has a truncated square pyramid shape that spreads toward the bottom in the -Z direction instead of the rectangular parallelepiped shape.

The pair of X end portions 216, 216 of the X side wall 208 in the X direction are curved in the Y direction. Therefore, the X end portions 216 of the X side wall 208 in the X direction oppose the Y side walls 207 in the X direction. The X side walls 208 are positioned on an inner side, and the Y side walls 207 are positioned on an outer side. When not accommodated in the rear case 100, the Y side wall 207 and the X side wall 208 are at least partially separated from each other in the X direction and/or the Y direction. In the present example, by the widening of the Y side walls 207 in the X direction, the Y side walls 207 and the pair of X end portions 216, 216 of each of the X side walls 208 oppose each other while being apart from each other in the X direction (FIG. 9).

One of the Y side wall 207 or the X side wall 208 includes one or more dowel convex portions 217 (convex portions) that protrude while opposing in the X direction in which the Y side wall 207 and the X side wall 208 oppose each other. In the present example, the X side wall 208 on the inner side includes two dowel convex portions 217, 217 that protrude toward the Y side wall 207 on the outer side in the X direction. The two dowel convex portions 217, 217 are arranged at the X end portion 216 of the X side wall 208 while at least being apart from each other in the Z direction. One of or the other one of the Y side wall 207 or the X side wall 208 includes one or more slit portions 218 that are provided between the two or more dowel convex portions 217, 217 in the Z direction and extend in a direction containing a component of a direction orthogonal to the Z direction. In the present example, the X side wall 208 includes the slit portion 218 that is provided between the two dowel convex portions 217, 217 and extends in the Y direction. Thus, portions 219, 219 of the X end portions 216 of the X side wall 208, at each of which the two dowel convex portions 217, 217 are provided, are each sectioned by the slit portion 218 to become a cantilever, with the result that the portions 219, 219 can be deformed (bow or the like) independently.

When not accommodated in the rear case 100, the Y side wall 207 and the X side wall 208 may be completely separated from each other (FIG. 9), or at least parts thereof may be in contact with each other (not shown). When at least parts thereof are in contact with each other, at least one dowel convex portion 217 may be in contact with the Y side wall 207, or a portion of the X end portion 216 of the X side wall 208 at which the dowel convex portions 217 are not provided may be in contact with the Y side wall 207, or both are possible.

### 5. Connection between rear chassis (first chassis) and rear case (first case)

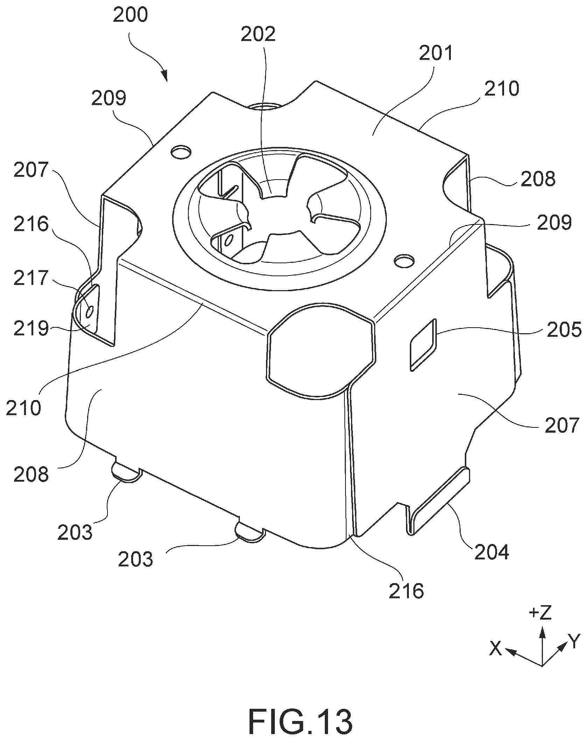

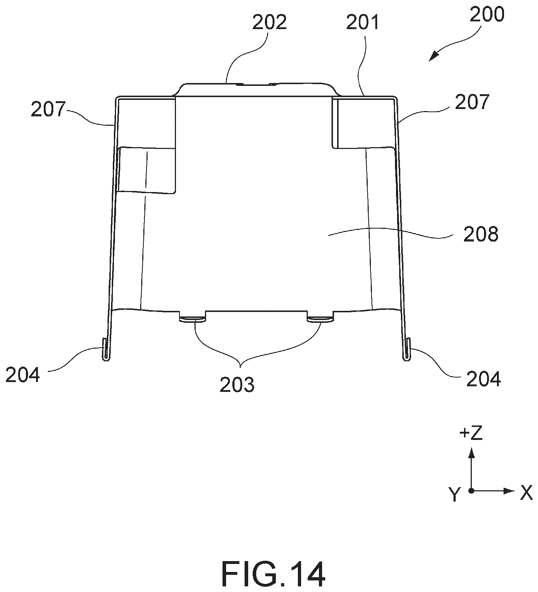

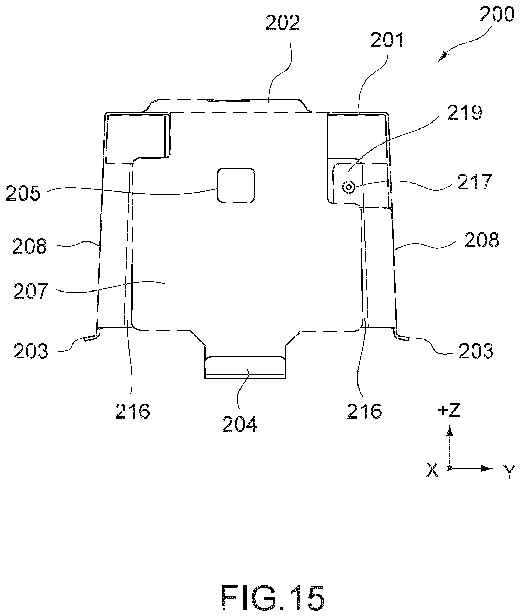

FIG. 11 is a perspective view illustrating a state where the rear chassis is attached to the rear case. FIG. 12 is a cross-sectional view illustrating the state where the rear chassis is attached to the rear case. FIG. 13 is a perspective view illustrating the rear chassis in the state shown in FIG. 11. FIG. 14 is a side view of the rear chassis in the state shown in FIG. 11, seen in the Y direction. FIG. 15 is a side view of the rear chassis in the state shown in FIG. 11, seen in the X direction.

The rear case 100 includes a pair of X side inner wall surfaces 104, 104 that extend in the X direction and each have a height in the Z direction and a pair of Y side inner wall surfaces 106, 106 that extend in the Y direction and each have a height in the Z direction. The rear case opening portion 102 of the rear case 100 faces the -Z direction. In the rear case 100, the rear case opening portion 102 is larger than the bottom surface 103, and the rear case 100 has a tapered shape that widens from the bottom surface 103 toward the rear case opening portion 102 in the **-Z** direction. Specifically, the pair of X side inner wall surfaces 104, 104 tilt in the Y direction. The pair of Y side inner wall surfaces 106, 106 tilt in the X direction. In other words, at least a part of a space formed by the pair of X side inner wall surfaces 104, 104, the pair of Y side inner wall surfaces 106, 106, and the bottom surface 103 of the rear case 100 has a truncated square pyramid shape that spreads toward the bottom in the **-Z** direction instead of the rectangular parallelepiped shape.

As described above, when not accommodated in the rear case 100, at least a part of the box portion 206 of the rear chassis 200 has a truncated square pyramid shape instead of the rectangular parallelepiped shape. Tilts of the X side inner wall surfaces 104 and the Y side inner wall surfaces 106 in the rear case 100 are smaller than the tilts of the Y side walls 207 and the X side walls 208 of the box portion 206 of the rear chassis 200. In other words, widening of the truncated square pyramid shape that spreads toward the bottom in the -Z direction is larger in the box portion 206 of the rear chassis 200 than in the rear case 100. Therefore, the internal space of the rear case 100 is smaller than that of the box portion 206 of the rear chassis 200. Thus, when the box portion 206 of the rear chassis 200 is accommodated in the rear case 100, the X side inner wall surfaces 104 of the rear case 100 press the X side walls 208 of the rear chassis 200 in the Y direction. Conversely, the X side walls 208 of the rear chassis 200 repel to widen in the Y direction toward the X side inner wall surfaces 104 of the rear case 100. In addition, the Y side inner wall surfaces 106 of the rear case 100 press the Y side walls 207 and the X end portions 216 of the X side walls 208 of the rear chassis 200 in the X direction. Conversely, the Y side walls 207 of the rear chassis 200 repel to widen in the X direction toward the Y side inner wall surfaces 106 of the rear case 100, and the X end portions 216 of the X side walls 208 repel to widen in the X direction toward the Y side walls 207 of rear chassis 200. Thus, the four surfaces of the rear chassis 200 are electrically connected to one another, and the box portion 206 of the rear chassis 200 is brought into close contact with a large portion of the X side inner wall surfaces 104 and Y side inner wall surfaces 106 of the rear case 100. Therefore, it is possible to take full advantage of the internal space of the rear case 100 and maximize the internal space for accommodating the components as the box-type rear chassis 200. In other words, since the box portion 206 of the rear chassis 200 and the rear case 100 have the truncated square pyramid shape that spreads toward the bottom on the rear case opening portion 102 side, spatial efficiency is higher than that of a right-angle-bent box structure. Further, the rear case 100 can stably retain the rear chassis 200 without a backlash so as to be capable of absorbing individual differences of each of the rear case 100 and the rear chassis 200. In addition, since the contact points can be secured without using burring caulking, spot welding, and the like, this contributes to simplification of component manufacturing processes and lowering of component costs. Furthermore, by maximizing the internal space, further another substrate (not shown) on which a processor which executes information processing that is different from the processing of the connector substrate 500 and the imager substrate 700 is mounted can be accommodated in the image pickup apparatus 2. In other words, the substrate unit 3 may further include a substrate different from the connector substrate 500 and the imager substrate 700.

When the rear chassis 200 is accommodated in the rear case 100, the dowel convex portions 217 of the X end portions 216 of the X side walls 208 come into contact with the Y side walls 207 in the X direction. The portions 219, 219 of the X end portions 216 of the X side walls 208, at each of which the two dowel convex portions 217, 217 are provided, are each sectioned by the slit portion 218 so as to be capable of being deformed (bowing or the like) independently. The two dowel convex portions 217, 217 can independently follow the Y side wall 207 of the rear chassis 200 as the contacting surface in the X direction so as to certainly come into contact with the Y side wall 207 in the X direction, and thus the electrical contact is secured. In other words, by accommodating the rear chassis 200 in the rear case 100, the Y side walls 207 and the X side walls 208 close to form the shape of the box portion 206, and thus the contact points by the dowel convex portions 217, 217 are secured. By providing the dowel convex portions 217, 217 at the X end portions 216 of the X side walls 208, the dowel convex portions 217, 217 are easily and certainly brought into contact with the Y side walls 207 as compared to a case where surface contact is assumed to be made without providing the dowel convex portions. Moreover, a possibility of occurrence of a contact failure due to variations in the rear chassis 200 and the rear case 100 is reduced, and it becomes easy to electrically connect the four surfaces of the rear chassis 200 to one another for sure.

At this time, the Y side inner wall surfaces 106 and X side inner wall surfaces 104 of the rear case 100 press at least one of the Y side walls 207 or the X side walls 208 (both in the present embodiment) in at least any one of directions orthogonal to the Z direction (both of the X direction and the Y direction in the present embodiment). Thus, a state where an electrical connection is established between the Y side walls 207 and the X side walls 208 is obtained. It is noted that as described above, when not accommodated in the rear case 100, the Y side wall 207 and the X side wall 208 of the box portion 206 of the rear chassis 200 may be completely separated from each other (FIG. 9), or at least parts thereof may be in contact with each other (not shown). The "state where an electrical connection is established" means establishing an electrical connection by bringing them into contact with each other when they are apart from each other, and continuing the electrical connection by the contact when at least parts thereof are in contact with each other, to thus obtain the state where an electrical connection is established between the Y side wall 207 and the X side wall 208.

### 6. Electrical connection between rear chassis (first chassis) and front chassis (second chassis)

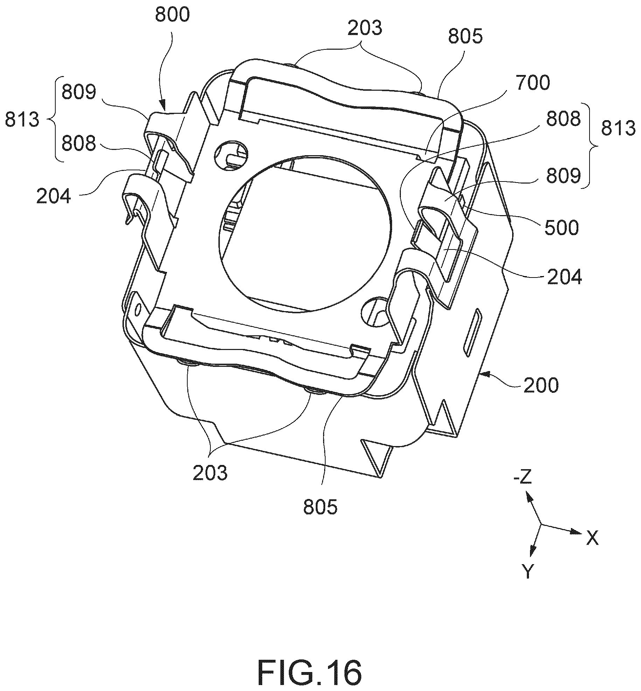

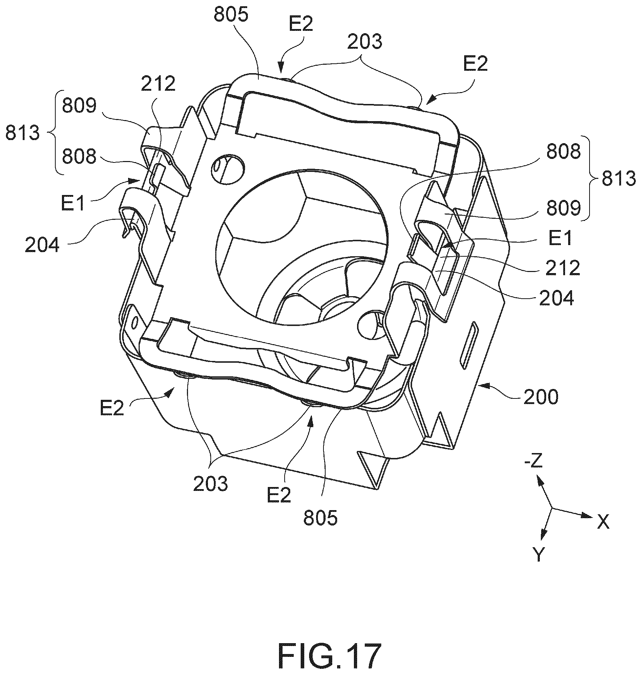

FIG. 16 is a perspective view illustrating a state after the rear chassis attached to the rear case (not shown) is attached to the front chassis attached to the front case (not shown). FIG. 17 is a perspective view illustrating the state after the rear chassis attached to the rear case (not shown) is attached to the front chassis attached to the front case (not shown).

The front case opening portion 1003 of the front case 1001 and the rear case opening portion 102 of the rear case 100 are bonded in the Z direction. In this bonded state, the pair of to-be-nipped-type contact members 204, 204 of the rear chassis 200 and the pair of catch-type contact members 813, 813 of the front chassis 800 are electrically connected at two or more (two in the present example) first contact points E1. In addition, the pair of pressing-type contact members 203, 203 of the rear chassis 200 and the pair of leaf-spring-type contact members 805, 805 of the front chassis 800 are electrically connected at two or more (four in the present example) second contact points E2. The rear chassis 200 and the front chassis 800 are fixed so as that these electrical connections are established. The two or more (two in the present example) first contact points E1 and the two or more (four in the present example) second contact points E2 are arranged at positions corresponding to four sides of a rectangle (rectangular shape) when seen in the Z direction.

When the rear case 100 and the front case 1001 are bonded in the Z direction, the front chassis 800 and the rear chassis 200 themselves that are each formed of a metal material are mechanically connected at the two or more first contact points E1 and the two or more second contact points E2, to thus be electrically connected and GND-bonded. The image pickup apparatus 2 does not include an electrical connection by members other than the rear chassis 200 and the front chassis 800, that are formed of a conductive material. For example, the image pickup apparatus 2 does not include conductive rubber for the electrical connection between the rear chassis 200 and the front chassis 800. This realizes excellent EMC and low costs since the number of components is small, and is advantageous in quality control since the number of manufacturing processes is small, as compared to the case of using conductive rubber.

Assuming that the conductive rubber is used for the electrical connection between the rear chassis 200 and the front chassis 800, the rear chassis 200 and the front chassis 800 may be capable of being electrically connected across a circumferential direction with respect to the Z axis. This point is advantageous when compared with the structure that does not use conductive rubber. However, in the present embodiment, the two or more (two in the present example) first contact points E1 and the two or more (four in the present example) second contact points E2 are arranged at positions corresponding to the four sides of a rectangle (rectangular shape) when seen in the Z direction. Therefore, despite the fact that the conductive rubber is not used, the rear chassis 200 and the front chassis 800 can be electrically connected substantially equally at the six points in the circumferential direction with respect to the Z axis, thus being advantageous from the viewpoint of EMC since a span of an electrically-unconnected state becomes short.

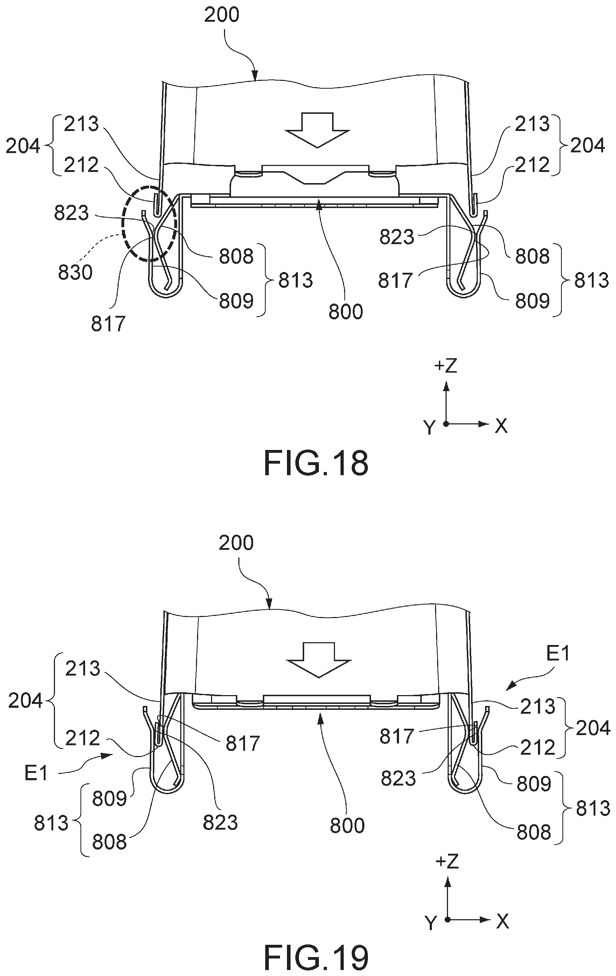

FIG. 18 is a side view illustrating a state before the rear chassis attached to the rear case (not shown) is attached to the front chassis attached to the front case (not shown), the side view seen in the Y direction. FIG. 19 is a side view illustrating a state after the rear chassis attached to the rear case (not shown) is attached to the front chassis attached to the front case (not shown), the side view seen in the Y direction.

First, an electrical connection between the pair of to-be-nipped-type contact members 204, 204 of the rear chassis 200 and the pair of catch-type contact members 813, 813 of the front chassis 800 at the two first contact points E1 will be described. As described above, when the front chassis 800 is attached to the front case 1001, the front chassis 800 is seen in the Y direction (FIG. 7). At this time, the second leaf spring contact points 823 of the second leaf spring 809 and the first leaf spring contact point 817 of the first leaf spring 808 come close to each other in the X direction to constitute the V-shaped catch structure 830. In the V-shaped catch structure 830, the first leaf spring 808 is not deformed and has its own elasticity. On the other hand, the second leaf spring 809 receives a pressing force directed toward the inner side of the X direction from the inner surface 1010 of the Y side wall 1006 of the front case 1001, and thus has a repulsion in the X direction, that is directed toward the Y side wall 1006 of the front case 1001. The to-be-nipped-type contact members 204 of the rear chassis 200 are pushed into and inserted into the catch-type contact members 813 constituting the V-shaped catch structure 830 when closed by the front case 1001, in the -Z direction (arrow shown in FIG. 18). Thus, the catch-type contact member 813 bows in the X direction so as to nip the to-be-nipped portion 212 of the to-be-nipped-type contact member 204 having a large thickness in the X direction. Thus, the to-be-nipped-type contact member 204 and the catch-type contact member 813 are electrically connected for sure at the first contact point E1. The rear case opening portion 102 of the rear case 100 and the front case opening portion 1003 of the front case 1001 are bonded in the Z direction. In this state, the Y positioning convex portions 1007 and Y side walls 1006 of the front case 1001 press the catch-type contact members 813 of the front chassis 800 against the to-be-nipped-type contact members 204 of the rear chassis 200 in the X direction. Thus, the Y positioning convex portions 1007 and the Y side walls 1006 cause the to-be-nipped-type contact members 204 and the catch-type contact members 813 to be electrically connected for sure at the first contact points E1.

When inserting the to-be-nipped-type contact members 204 of the rear chassis 200, the positions of the to-be-nipped-type contact members 204 of the rear chassis 200 in the X direction and/or the Y direction may vary depending on individual differences or workers. However, when inserting the to-be-nipped-type contact members 204 of the rear chassis 200, the to-be-nipped portion 212 having a large thickness comes into contact with at least one of the second leaf spring 809 or the first leaf spring 808 constituting the V-shaped catch structure 830. Therefore, the to-be-nipped-type contact member 204 can certainly be inserted into the V-shaped catch structure 830. In addition, after the insertion, the to-be-nipped portion 212 of the to-be-nipped-type contact member 204 having a large thickness is electrically connected (GND-bonded) for sure to at least one of the second leaf spring 809 or the first leaf spring 808.

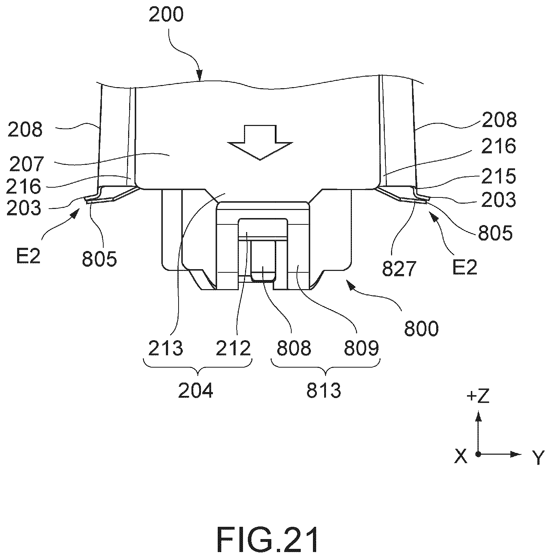

FIG. 20 is a side view illustrating the state before the rear chassis attached to the rear case (not shown) is attached to the front chassis attached to the front case (not shown) (the state shown in FIG. 18), the side view seen in the X direction. FIG. 21 is a side view illustrating the state after the rear chassis attached to the rear case (not shown) is attached to the front chassis attached to the front case (not shown) (the state shown in FIG. 19), the side view seen in the X direction.

Next, the electrical connection between the pair of pressing-type contact members 203, 203 of the rear chassis 200 and the pair of leaf-spring-type contact members 805, 805 of the front chassis 800 at the four second contact points E2 will be described. A relationship between the leaf-spring-type contact member 805 of the front chassis 800 and the pressing-type contact member 203 of the rear chassis 200 is as follows. A length of the leaf-spring-type contact member 805 of the front chassis 800 from the second fulcrum point 806 in the Y direction is larger than a length of the pressing-type contact member 203 of the rear chassis 200 from the first fulcrum point 215 in the Y direction. Therefore, the leaf-spring-type contact member 805 of the front chassis 800 bows more easily in the -Z direction than the pressing-type contact member 203 of the rear chassis 200. Also with the structure in which the space portion 810 is provided on the inner side of the leaf-spring-type contact member 805, the second leaf spring 809 has a leaf spring structure with which it can flexibly bow in the Z direction while using the pair of second fulcrum points 806, 806 as the fulcrums. Conversely, the pressing-type contact member 203 of the rear chassis 200 is more robust than the leaf-spring-type contact member 805 of the front chassis 800. The second fulcrum points 806 of the front chassis 800 are positioned more on the inner side of the image pickup apparatus 2 in the Y direction than the first fulcrum points 215 of the rear chassis 200. The pressing-type contact member 203 of the rear chassis 200 is tilted toward the leaf-spring-type contact member 805 of the front chassis 800. At the second contact point E2, the tilt angle of the pressing-type contact member 203 of the rear chassis 200 with respect to the Y direction and the -Z direction is larger than the tilt angle of the leaf-spring-type contact member 805 of the front chassis 800 with respect to the Y direction and the -Z direction.

The rear case opening portion 102 of the rear case 100 and the front case opening portion 1003 of the front case 1001 are bonded in the Z direction. At this time, the two pressing-type contact members 203, 203 of the rear chassis 200 relatively push the leaf-spring-type contact member 805 of the front chassis 800 in the **-Z** direction (arrow shown in FIG. 20). Thus, the rear case opening portion 102 of the rear case 100 and the front case opening portion 1003 of the front case 1001 are bonded in the Z direction. At this time, the two pressing-type contact members 203, 203 of the rear chassis 200 and the leaf-spring-type contact member 805 of the front chassis 800 relatively push each other in the Z direction. Thus, the two pressing-type contact members 203, 203 and the leaf-spring-type contact member 805 are electrically connected for sure at the two second contact points E2. Specifically, bending tip end portions of the pressing-type contact members 203 of the rear chassis 200 are tilted in the -Z direction. Therefore, when coming into contact with the leaf-spring-type contact member 805 of the front chassis 800, the two pressing-type contact members 203, 203 press the first longitudinal portion 827 of the leaf-spring-type contact member 805 at positions farthest from the second fulcrum points 806 of the leaf-spring-type contact member 805. Therefore, the leaf-spring-type contact member 805 of the front chassis 800 is pushed downwardly to bow in the -Z direction. However, no unreasonable stress is generated in the cantilever-type leaf spring structure of the leaf-spring-type contact member 805. In this state, the two pressing-type contact members 203, 203 of the rear chassis 200 and the leaf-spring-type contact member 805 of the front chassis 800 are stably electrically connected (GND-bonded) for sure.

Thus, the connector substrate 500 and the imager substrate 700 are enclosed by the box shape formed by the chassis including the rear chassis 200 and the front chassis 800 to be electrically shielded (FIG. 16). In addition, the rear chassis 200 and the front chassis 800 are GND-connected at the total of six positions, that is, the two first contact points E1 and the four second contact points E2. Specifically, the two first contact points E1 and the four second contact points E2 are arranged at positions corresponding to all four sides of a rectangle (rectangular shape) when seen in the Z direction. Thus, it is advantageous from the viewpoint of EMC since the span of the electrically-unconnected state becomes short. In addition, the rear chassis 200 and the front chassis 800 are GND-connected at the total of six positions. Thus, a gap between the rear chassis 200 and the front chassis 800 is minimized, which is advantageous from the viewpoint of EMC. In addition, the rear chassis 200 and the front chassis 800 are GND-connected at the total of six positions. Thus, heat can be efficiently transmitted to the front chassis 800 via the rear chassis 200. Heat of a built-in device that generates heat can be efficiently released to the rear case 100 and the front case 1001 as the outer housings of the image pickup apparatus 2 via the rear chassis 200 and the front chassis 800.

The connection positions between the rear chassis 200 and the front chassis 800 will be described. A bonding force at the first contact point E1 (a force with which the catch-type contact member 813 nips the to-be-nipped-type contact member 204 in the X direction) is larger than a bonding force at the second contact point E2 (a force with which the pressing-type contact members 203 causes the leaf-spring-type contact member 805 to bow in the -Z direction and repel). Thus, since the rear chassis 200 is retained at the insertion position after being inserted into the front chassis 800, welding between the rear case 100 and the front case 1001 can be performed in a stable state.

### 7. Modified example

### (1) Modified example related to dowel convex portions 217 of rear chassis 200

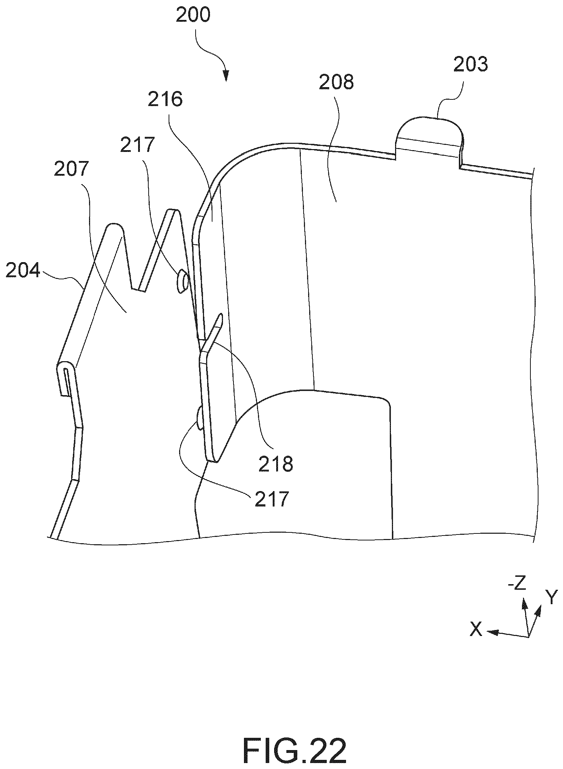

FIG. 22 is a partial perspective view illustrating a rear chassis according to a modified example.

Instead of the X side wall 208 of the rear chassis 200 including the dowel convex portions 217, the Y side wall 207 may include the dowel convex portions 217. In this case, the slit portion 218 may be provided in the X side wall 208 not provided with the dowel convex portions 217, 217 (FIG. 22). Alternatively, the slit portion 218 may be provided in the Y side wall 207 provided with the dowel convex portions 217, 217. Alternatively, the slit portion 218 may be provided in both of the Y side wall 207 and the X side wall 208. Alternatively, the slit portion 218 does not need to be provided in neither the Y side wall 207 nor the X side wall 208.

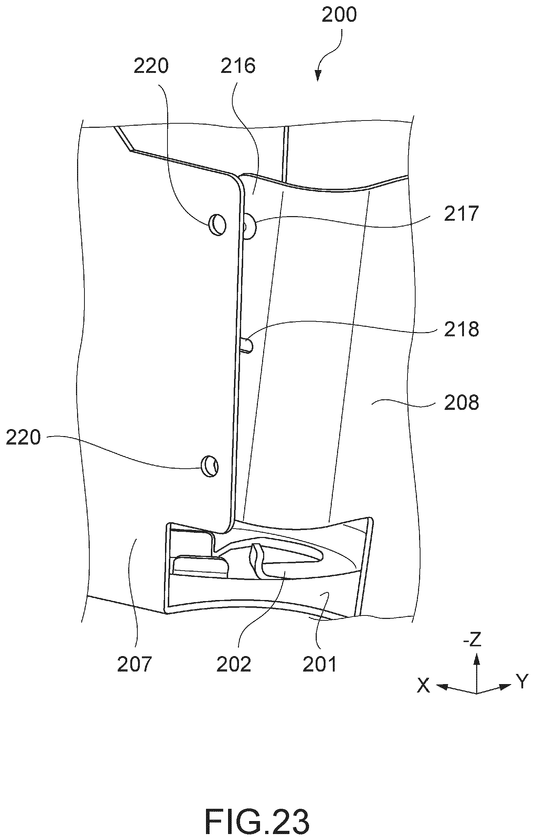

FIG. 23 is a partial perspective view illustrating a rear chassis according to another modified example.

The Y side wall 207 of the rear chassis 200 may include receiving holes 220, 220 that respectively engage with the dowel convex portions 217, 217 of the X side wall 208. The dowel convex portions 217, 217 respectively engage with the receiving holes 220, 220. Thus, a possibility of occurrence of a contact failure due to variations in the rear chassis 200 and the rear case 100 is reduced, and it becomes easy to electrically connect the four surfaces of the rear chassis 200 to one another for sure. The receiving holes 220, 220 may be through-holes or holes with bottoms. The slit portion 218 may be provided in the Y side wall 207 including the receiving holes 220, 220 and/or the X side wall 208 including the dowel convex portions 217, 217.

Although not shown, modified examples as follows are also possible. The slit portion 218 may be provided in the Y side wall 207 not provided with the dowel convex portions 217, 217 instead of the X side wall 208 provided with the dowel convex portions 217, 217. Alternatively, the slit portion 218 may be provided in both of the Y side wall 207 and the X side wall 208.

The X side wall 208 of the rear chassis 200 does not need to include the slit portion 218. In other words, the two dowel convex portions 217, 217 do not need to be sectioned by the slit portion 218.

The X side wall 208 of the rear chassis 200 may include one dowel convex portion 217.

The X side wall 208 of the rear chassis 200 may include three or more dowel convex portions 217. In this case, the slit portion 218 may be provided between at least some of the dowel convex portions 217, 217 adjacent to each other. The slit portion 218 may be provided between all of the adjacent dowel convex portions 217, 217. Alternatively, the X side wall 208 does not need to include the slit portion 218.

Both of the Y side wall 207 and the X side wall 208 of the rear chassis 200 do not need to include the dowel convex portion 217. In this case, the Y side wall 207 and the X end portion 216 of the X side wall 208 come into surface contact with each other. In this case, the slit portion 218 may be provided in the Y side wall 207 and/or the X side wall 208.

As described above, when not accommodated in the rear case 100, the Y side wall 207 and X side wall 208 of the rear chassis 200 may completely be separated from each other (FIG. 9), or at least parts thereof may be in contact with each other (not shown). When at least parts thereof are in contact with each other, at least one dowel convex portion 217 may come into contact with the Y side wall 207. Alternatively, a portion of the X end portion 216 of the X side wall 208 at which the dowel convex portion 217 is not provided may come into contact with the Y side wall 207, or both are possible.

### (2) Modified example related to pressing-type contact member 203 of rear chassis 200 and leaf-spring-type contact member 805 of front chassis 800

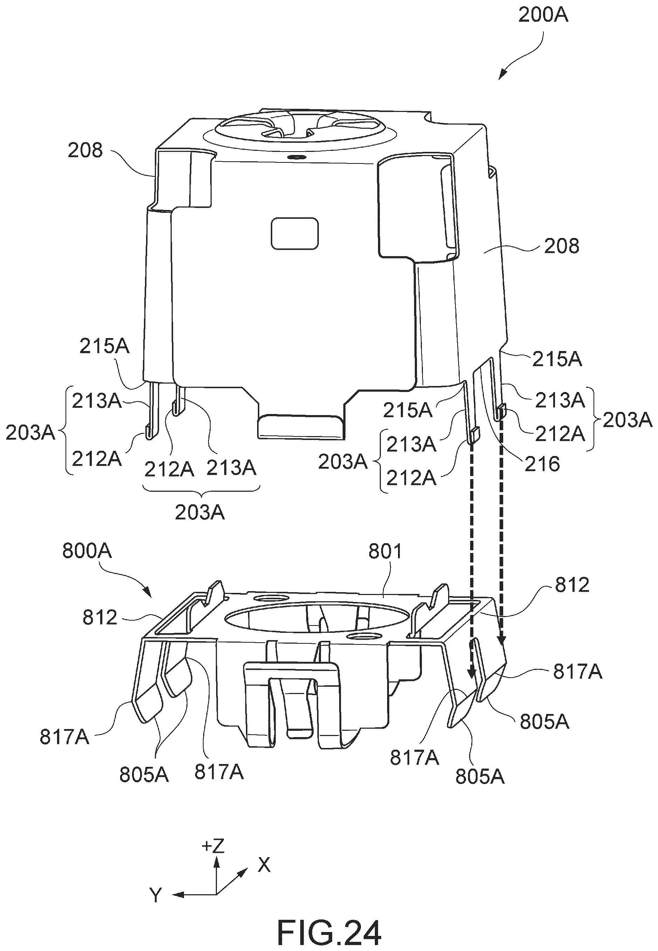

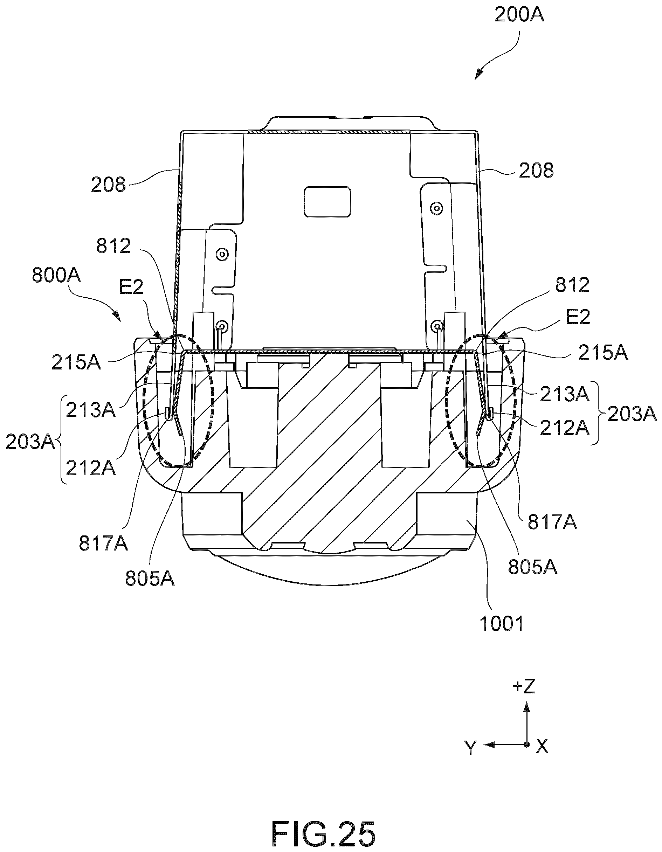

FIG. 24 is a perspective view illustrating a rear chassis and a front chassis according to a modified example. FIG. 25 schematically illustrates the rear chassis and the front chassis attached to the front case.

In the embodiment above, the leaf-spring-type contact member 805 of the front chassis 800 can bow in the Z direction. In place of this, leaf-spring-type contact members 805A of a front chassis 800A may be capable of bowing in the Y direction. It is assumed that the rear case opening portion 102 of the rear case 100 and the front case opening portion 1003 of the front case 1001 are bonded in the Z direction. In this state, it is assumed that second contact point E2 members 203A of a rear chassis 200A and the leaf-spring-type contact members 805A of the front chassis 800A relatively push each other in the Y direction. Thus, the pressing-type contact members 203A and the leaf-spring-type contact members 805A may be electrically connected at the second contact points E2.

According to the modified example, two or more (two in the present example) pressing-type contact members 203A, 203A that respectively protrude from first fulcrum points 215A in the -Z direction are provided at the X end portion 216 that is an end portion of the X side wall 208 of the rear chassis 200A in the -Z direction. In other words, the rear chassis 200A includes a total of four pressing-type contact members 203A. The two pressing-type contact members 203A, 203A are positioned apart from each other in the X direction at the X end portion 216. The pressing-type contact member 203A includes a to-be-nipped portion 212A and a non-contact portion 213A. The to-be-nipped portion 212A is a portion that comes into contact with the leaf-spring-type contact member 805A when the rear chassis 200A and the front chassis 800A are fixed by the front case 1001. The non-contact portion 213A is a portion not in contact with the leaf-spring-type contact member 805A. A thickness of the to-be-nipped portion 212A in the X direction is larger than a thickness of the non-contact portion 213A in the X direction. For example, the to-be-nipped portion 212A is folded 180 degrees in the Z direction so that the thickness thereof in the X direction becomes twice the thickness of the non-contact portion 213A.

The leaf-spring-type contact members 805A of the front chassis 800A are provided at each of the X sides 812 of the front chassis base portion 801. The leaf-spring-type contact members 805A can bow in the Y direction. Specifically, the leaf-spring-type contact members 805A protrude in a form of a cantilever from the X side 812 in the direction containing the components of the Y direction and the -Z direction and are mountain-bent at leaf spring contact points 817A. The leaf spring contact points 817A that are each an apex of the mountain protrude in a direction in which distances thereof from the front chassis base portion 801 increase in the Y direction. With this structure, the leaf-spring-type contact members 805A can bow in the Y direction from the X side 812 as the fulcrum.

The X side 812 as the fulcrum of the leaf-spring-type contact members 805A of the front chassis 800A is positioned more on the inner side of the image pickup apparatus 2 in the Y direction than the first fulcrum points 215A of the rear chassis 200A. A tilt angle A of the leaf-spring-type contact members 805A of the front chassis 800A with respect to the Y direction and the -Z direction is larger than a tilt angle A of the pressing-type contact members 203 of the rear chassis 200A with respect to the Y direction and the -Z direction. With this configuration, the rear case opening portion 102 of the rear case 100 and the front case opening portion 1003 of the front case 1001 are bonded in the Z direction. In this state, the to-be-nipped portions 212A of the second contact point E2 members 203A of the rear chassis 200A press the leaf spring contact points 817A of the leaf-spring-type contact members 805A of the front chassis 800A in the Y direction toward the inner side of the front chassis 800A. Thus, the pressing-type contact members 203A and the leaf-spring-type contact members 805A are electrically connected at the second contact points E2.

### (3) Another modified example related to pressing-type contact member 203 of rear chassis 200 and leaf-spring-type contact member 805 of front chassis 800

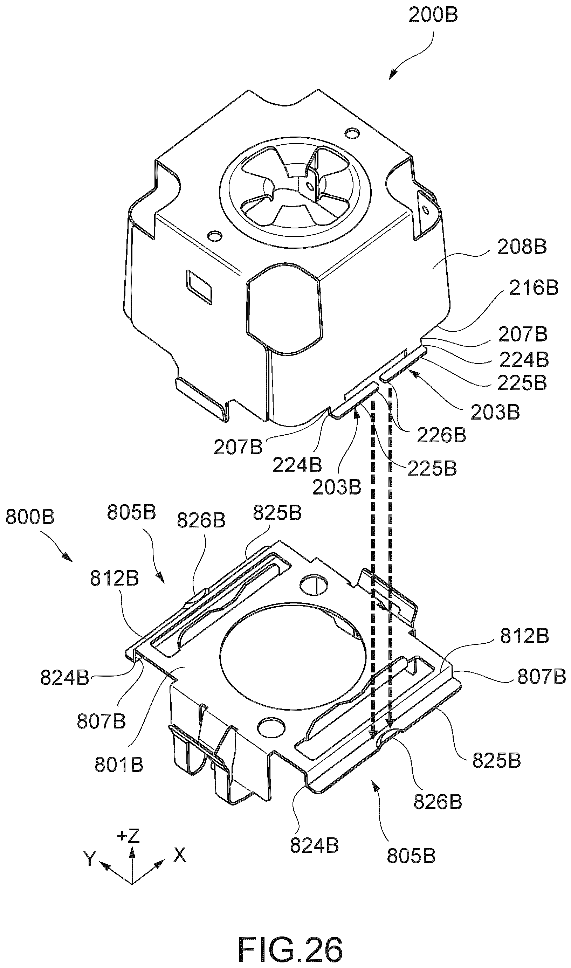

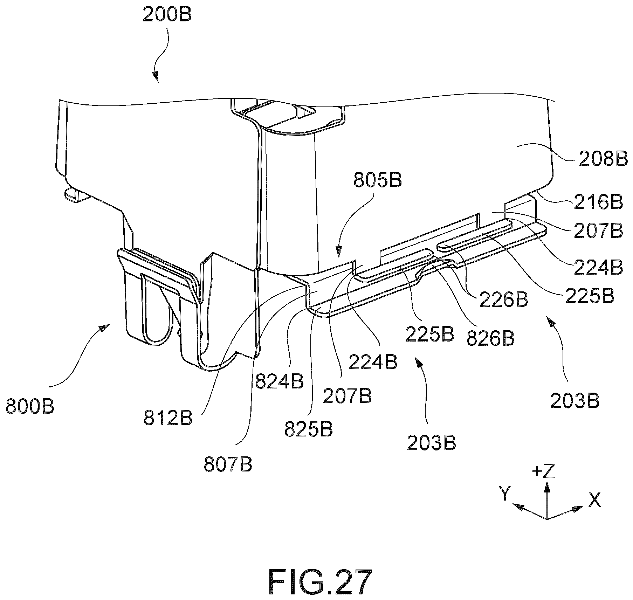

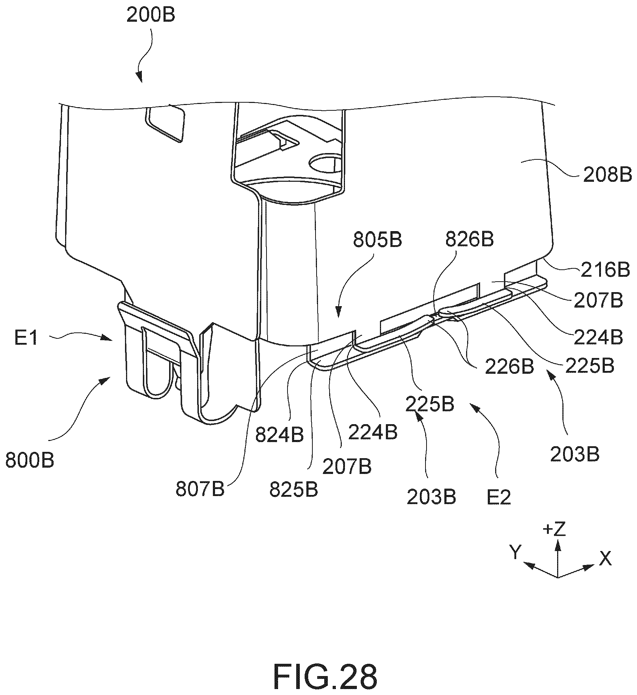

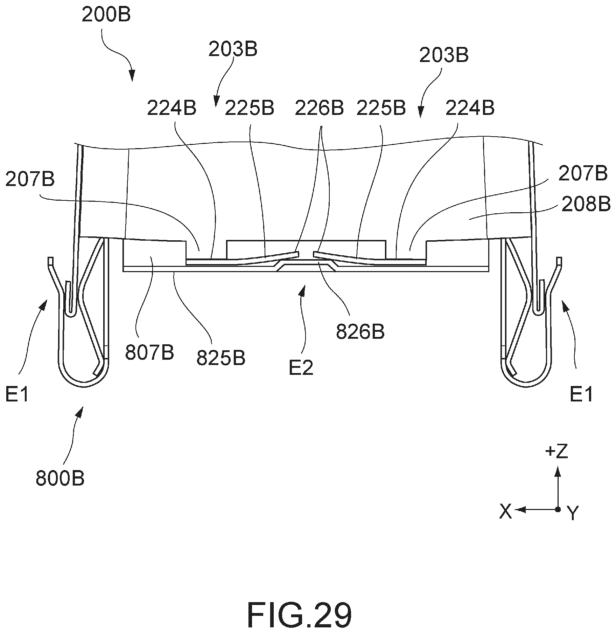

FIG. 26 is a perspective view illustrating a rear chassis and a front chassis according to another modified example. FIG. 27 is a partial perspective view illustrating the rear chassis and the front chassis before being attached. FIG. 28 is a partial perspective view illustrating the rear chassis and the front chassis after being attached. FIG. 29 is a partial side view of the rear chassis and the front chassis after being attached, the view seen in the Y direction.

In the embodiment above, the leaf-spring-type contact member 805 of the front chassis 800 is more easily deformed in the -Z direction than the pressing-type contact member 203 of the rear chassis 200. Conversely, the pressing-type contact member 203 of the rear chassis 200 is more robust than the leaf-spring-type contact member 805 of the front chassis 800. Therefore, when the pressing-type contact members 203, 203 of the rear chassis 200 press the first longitudinal portion 827 of the leaf-spring-type contact member 805 in the -Z direction, the leaf-spring-type contact member 805 of the front chassis 800 is pushed downwardly to bow in the -Z direction. The two pressing-type contact members 203, 203 of the rear chassis 200 and the leaf-spring-type contact member 805 of the front chassis 800 are electrically connected at the second contact points E2.

Alternatively, according to another modified example, a rear chassis 200B includes leaf-spring-type contact members 203B, and a front chassis 800B includes pressing-type contact members 805B. The leaf-spring-type contact members 203B of the rear chassis 200B more easily bow in the +Z direction than the pressing-type contact members 805B of the front chassis 800B. Conversely, the pressing-type contact members 805B of the front chassis 800B are more robust than the leaf-spring-type contact members 203B of the rear chassis 200B. Therefore, the rear case opening portion 102 of the rear case 100 and the front case opening portion 1003 of the front case 1001 are bonded in the Z direction. In this state, the leaf-spring-type contact members 203B of the rear chassis 200B are pushed upwardly to bow in the +Z direction by the pressing-type contact members 805B of the front chassis 800B. The leaf-spring-type contact members 203B of the rear chassis 200B and the pressing-type contact members 805B of the front chassis 800B are electrically connected.

Specifically, the pressing-type contact member 805B of the front chassis 800B includes an arm portion 807B that is bent from an X side 812B of the front chassis base portion 801B in the -Z direction. A tip end 824B of the arm portion 807B in the -Z direction includes a longitudinal portion 825B that is parallel to the XY plane and extends in the X direction. The longitudinal portion 825B and the front chassis base portion 801B are positioned apart from each other in the Z direction and are parallel to the XY plane. With this structure, the pressing-type contact member 805B has a Z-bending structure that is bent at the X side 812B of the front chassis base portion 801B and the tip end 824B. The longitudinal portion 825B extends linearly in the X direction. A protrusion portion 826B that protrudes in the +Z direction is provided at a center portion of the longitudinal portion 825B in the X direction.

Two or more (two in the present example) leaf-spring-type contact members 203B, 203B are provided at an X end portion 216B that is an end portion of an X side wall 208B of the rear chassis 200B in the -Z direction. In other words, the rear chassis 200B includes a total of four leaf-spring-type contact members 203B. The two leaf-spring-type contact members 203B, 203B are positioned apart from each other in the X direction at the X end portion 216B. The leaf-spring-type contact members 203B each include an arm portion 207B that is bent from the X end portion 216B of the X side wall 208B in the -Z direction. A tip end 224B of the arm portion 207B in the -Z direction includes a longitudinal portion 225B that is parallel to the XY plane and extends in the X direction. Tip end portions 226B, 226B of the respective longitudinal portions 225B, 225B of the two leaf-spring-type contact members 203B, 203B provided at the common X end portion 216B oppose each other in the X direction with a space provided therebetween. The tip end portions 226B, 226B oppose the protrusion portion 826B of the pressing-type contact member 805B of the front chassis 800B in the Z direction.

The rear case opening portion 102 of the rear case 100 and the front case opening portion 1003 of the front case 1001 are bonded in the Z direction. In this state, the two leaf-spring-type contact members 203B, 203B of the rear chassis 200B and the pressing-type contact member 805B of the front chassis 800B relatively push each other in the Z direction. Thus, the two leaf-spring-type contact members 203B, 203B and the pressing-type contact member 805B are electrically connected at the two or more second contact points E2. Specifically, a root of the longitudinal portion 225B of the leaf-spring-type contact member 203B of the rear chassis 200B (a portion continuous with the arm portion 207B) is pressed against the longitudinal portion 825B of the pressing-type contact member 805B of the front chassis 800B in the -Z direction. The tip end portions 226B of the longitudinal portions 225B of the leaf-spring-type contact members 203B of the rear chassis 200B are pushed upwardly in the +Z direction by the protrusion portion 826B of the pressing-type contact member 805B of the front chassis 800B. Thus, one leaf-spring-type contact member 203B is electrically connected to the pressing-type contact member 805B at two second contact points E2. Accordingly, the rear chassis 200B and the front chassis 800B are electrically connected at the total of eight second contact points E2. With this structure, the tip end portions 226B of the longitudinal portions 225B of the leaf-spring-type contact members 203B of the rear chassis 200B are pushed upwardly in the +Z direction by the protrusion portion 826B of the pressing-type contact member 805B of the front chassis 800B at positions farthest from the roots thereof. Therefore, the longitudinal portions 225B of the leaf-spring-type contact members 203B of the rear chassis 200B are pushed upwardly to bow in the +Z direction. However, no unreasonable stress is generated in the cantilever-type leaf spring structure of the leaf-spring-type contact members 203B. Thus, the two leaf-spring-type contact members 203B, 203B of the rear chassis 200B and the pressing-type contact member 805B of the front chassis 800B are stably electrically connected (GND-bonded) for sure.

### 8. Configuration of vehicle

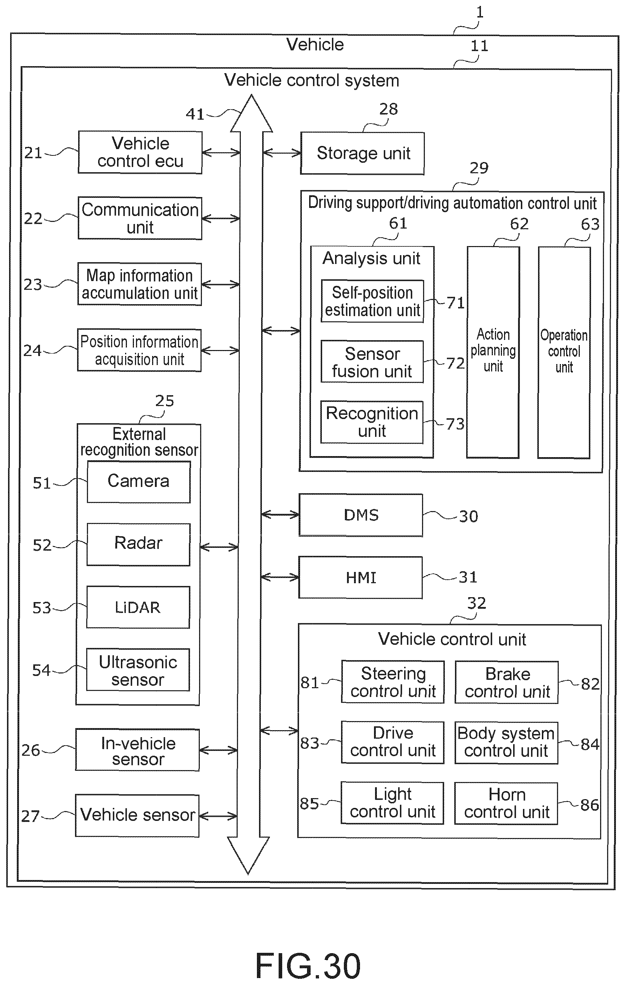

FIG. 30 is a block diagram illustrating a configuration example of a vehicle control system of a vehicle to which the present technology is applied.

The image pickup apparatus 2 according to the present embodiment can be used as a camera 51 to be described later.

A vehicle control system 11 is provided in a vehicle 1 and performs processing related to driving support and driving automation of the vehicle 1.

The vehicle control system 11 includes a vehicle control ECU (Electronic Control Unit) 21, a communication unit 22, a map information accumulation unit 23, a position information acquisition unit 24, an external recognition sensor 25, an in-vehicle sensor 26, a vehicle sensor 27, a storage unit 28, a driving support/driving automation control unit 29, a DMS (Driver Monitoring System) 30, an HMI (Human Machine Interface) 31, and a vehicle control unit 32.

The vehicle control ECU 21, the communication unit 22, the map information accumulation unit 23, the position information acquisition unit 24, the external recognition sensor 25, the in-vehicle sensor 26, the vehicle sensor 27, the storage unit 28, the driving support/driving automation control unit 29, the driver monitoring system (DMS) 30, the human machine interface (HMI) 31, and the vehicle control unit 32 are communicably connected to each other via a communication network 41. The communication network 41 includes, for example, an in-vehicle communication network, a bus, and/or the like compliant with a digital bidirectional communication standard such as a CAN (Controller Area Network), a LIN (Local Interconnect Network), a LAN (Local Area Network), FlexRay^{®}, or Ethernet^{®}. The communication network 41 may be selectively used depending on the type of data to be transmitted. For example, the CAN may be used for data related to vehicle control, and the Ethernet may be used for large-volume data. It is noted that the respective units of the vehicle control system 11 may be connected not via the communication network 41 but directly via wireless communication that assumes communication at a relatively short distance, such as near-field communication (NFC) and Bluetooth^{®}.

It is noted that hereinafter, when the respective units of the vehicle control system 11 communicate with each other via the communication network 41, the communication network 41 will not be described. For example, when the vehicle control ECU 21 and the communication unit 22 communicate with each other via the communication network 41, it is simply described that the vehicle control ECU 21 and the communication unit 22 communicate with each other.

The vehicle control ECU 21 is implemented by, for example, various processors such as a CPU (Central Processing Unit) and/or an MPU (Micro Processing Unit). The vehicle control ECU 21 controls all or a part of the functions of the vehicle control system 11.

The communication unit 22 communicates with various devices inside and outside the vehicle, other vehicles, servers, base stations, and/or the like, to transmit and receive various types of data. At this time, the communication unit 22 can communicate using a plurality of communication technologies.

Communication with outside the vehicle that the communication unit 22 is capable of executing will be schematically described. The communication unit 22 communicates with a server or the like existing on an external network (hereinafter, referred to as an external server) via a base station or an access point by a wireless communication technology, examples of which include 5G (5th generation mobile communication system), LTE (Long Term Evolution), DSRC (Dedicated Short Range Communications), and the like. The external network with which the communication unit 22 communicates is, for example, the Internet, a cloud network, a company-specific network, or the like. The communication technology used by the communication unit 22 to communicate with the external network is not particularly limited as long as it is a wireless communication technology that enables digital bidirectional communication to be performed at a communication speed equal to or more than a predetermined speed and at a distance equal to or more than a predetermined distance.

Further, for example, the communication unit 22 can communicate with terminals existing in the vicinity of the vehicle using a P2P (Peer To Peer) technology. The terminals existing in the vicinity of the vehicle include, for example, a terminal worn by a body moving at a relatively low speed, such as a pedestrian or a bicycle, a terminal installed at a fixed position in a store or the like, or an MTC (Machine Type Communication) terminal. Further, the communication unit 22 can also perform V2X communication. The V2X communication refers to communication between a vehicle and another entity, examples of which include vehicle-to-vehicle communication with another vehicle, vehicle-to-infrastructure communication with a roadside device or the like, vehicle-to-home communication with a home, and vehicle-to-pedestrian communication with a terminal or the like carried by a pedestrian.

The communication unit 22 can receive a program for updating software for controlling the operation of the vehicle control system 11 from outside (Over The Air). The communication unit 22 can receive map information, traffic information, information around the vehicle 1, and/or the like from outside. Further, the communication unit 22 can transmit information regarding the vehicle 1, information around the vehicle 1, and/or the like to the outside, for example. Examples of the information regarding the vehicle 1 that is transmitted to the outside by the communication unit 22 include data indicating the state of the vehicle 1, a recognition result by a recognition unit 73, and the like. In addition, the communication unit 22 performs communication that supports a vehicle emergency call system such as eCall, for example.

For example, the communication unit 22 receives an electromagnetic wave transmitted by a road traffic information communication system (VICS (Vehicle Information and Communication System)^{®}), the electromagnetic wave being transmitted using a radio wave beacon, an optical beacon, and/or FM multiplex broadcasting.

Communication with the inside of the vehicle that the communication unit 22 is capable of executing will be schematically described. The communication unit 22 can communicate with respective devices in the vehicle using wireless communication, for example. For example, the communication unit 22 can wirelessly communicate with an in-vehicle device by a wireless communication technology that enables digital bidirectional communication at a communication speed equal to or more than a predetermined speed, examples of which include wireless LAN, Bluetooth, NFC, and WUSB (Wireless USB). The communication unit 22 is not limited thereto and can communicate with the in-vehicle devices using wired communication. For example, the communication unit 22 can communicate with the respective in-vehicle devices by wired communication via a cable connected to a connection terminal (not shown). The communication unit 22 can communicate with the respective in-vehicle devices by a wired communication technology that enables digital bidirectional communication at a communication speed equal to or more than a predetermined speed, examples of which include USB (Universal Serial Bus), HDMI (High-Definition Multimedia Interface)^{®}, and MHL (Mobile High-Definition Link).

Here, the in-vehicle devices refer to, for example, devices that are not connected to the communication network 41 in the vehicle. Examples of the in-vehicle devices include a mobile device or a wearable device carried by a person on board such as a driver, an information device brought into and temporarily installed in the vehicle, and the like.

The map information accumulation unit 23 accumulates one or both of a map acquired from outside and/or a map created by the vehicle 1. For example, the map information accumulation unit 23 accumulates a three-dimensional high-precision map, a global map having lower precision than the high-precision map and covering a wide area, and/or the like.

The high-precision map is, for example, a dynamic map, a point cloud map, a vector map, or the like. The dynamic map is, for example, a map including four layers of dynamic information, semi-dynamic information, semi-static information, and static information, and is provided to the vehicle 1 from an external server or the like. The point cloud map is a map including a point cloud (point group data). The vector map is, for example, a map in which traffic information such as positions of lanes and/or traffic lights is associated with a point cloud map, for adaptation to ADAS (Advanced Driver Assistance System) and AD (Autonomous Driving).

The point cloud map and the vector map may be, for example, provided from an external server or the like, or may be created by the vehicle 1 as a map to be matched with a local map to be described later based on sensing results by a camera 51, a radar 52, a LiDAR 53, and the like, and may be accumulated in the map information accumulation unit 23. Furthermore, in a case where a high-precision map is provided from an external server or the like, for example, map data of several hundred square meters regarding a planned path on which the vehicle 1 is to travel is acquired from the external server or the like in order to reduce the amount of communication.

The position information acquisition unit 24 receives a GNSS (Global Navigation Satellite System) signal from a GNSS satellite and acquires position information of the vehicle 1. The acquired position information is supplied to the driving support/driving automation control unit 29. It is noted that the position information acquisition unit 24 is not limited to the technology that uses GNSS signals and may acquire position information using a beacon or the like, for example.

The external recognition sensor 25 includes various sensors used for recognizing a situation outside the vehicle 1, and supplies sensor data from the respective sensors to the respective units of the vehicle control system 11. The external recognition sensor 25 may include any type and any number of sensors.

For example, the external recognition sensor 25 includes the camera 51, the radar 52, the LiDAR (Light Detection and Ranging / Laser Imaging Detection and Ranging) 53, and an ultrasonic sensor 54. The external recognition sensor 25 is not limited thereto, and the external recognition sensor 25 may include one or more types of sensors among the camera 51, the radar 52, the LiDAR 53, and the ultrasonic sensor 54. The numbers of the cameras 51, the radars 52, the LiDAR 53, and the ultrasonic sensors 54 are not particularly limited as long as they can be practically installed in the vehicle 1. Furthermore, the type of sensor included in the external recognition sensor 25 is not limited to this example, and the external recognition sensor 25 may include another type of sensor. An example of the sensing area of each sensor included in the external recognition sensor 25 will be described later.

It is noted that an imaging method of the camera 51 is not particularly limited. For example, cameras that use various imaging methods, such as a TOF (Time Of Flight) camera, a stereo camera, a monocular camera, and an infrared camera that are capable of performing distance measurement can be applied to the camera 51 as necessary. The camera 51 is not limited thereto and may be a camera for simply acquiring a captured image regardless of distance measurement.

Further, for example, the external recognition sensor 25 can include an environment sensor for detecting an environment of the vehicle 1. The environment sensor is a sensor for detecting an environment including weather, meteorological phenomenon, brightness, and the like and can include, for example, various sensors such as a rain drop sensor, a fog sensor, a sunshine sensor, a snow sensor, and/or an illuminance sensor.

Furthermore, for example, the external recognition sensor 25 includes a microphone used for detecting sound around the vehicle 1, a position of a sound source, and/or the like.

The in-vehicle sensor 26 includes various sensors for detecting information inside the vehicle, and supplies sensor data from the respective sensors to the respective units of the vehicle control system 11. The type and number of the various sensors included in the in-vehicle sensor 26 are not particularly limited as long as the types and numbers allow practical installation of the sensors in the vehicle 1.

For example, the in-vehicle sensor 26 can include one or more types of sensors out of a camera, a radar, a seating sensor, a steering wheel sensor, a microphone, and a biological sensor. As the camera included in the in-vehicle sensor 26, cameras that use various imaging methods capable of measuring a distance can be used, examples of which include a ToF camera, a stereo camera, a monocular camera, and an infrared camera. The camera included in the in-vehicle sensor 26 is not limited thereto, and the camera may be a camera for simply acquiring a captured image regardless of distance measurement. The biological sensor included in the in-vehicle sensor 26 is provided, for example, in a seat, a steering wheel, or the like, to detect various types of biological information of a person on board such as a driver.

The vehicle sensor 27 includes various sensors for detecting the state of the vehicle 1, and supplies sensor data from the respective sensors to the respective units of the vehicle control system 11. The type and number of the various sensors included in the vehicle sensor 27 are not particularly limited as long as the types and numbers allow practical installation of the sensors in the vehicle 1.

For example, the vehicle sensor 27 includes a speed sensor, an acceleration sensor, an angular velocity sensor (gyro sensor), and an inertial measurement unit (IMU (Inertial Measurement Unit)) obtained by integrating these sensors. For example, the vehicle sensor 27 includes a steering angle sensor that detects a steering angle of a steering wheel, a yaw rate sensor, an accelerator sensor that detects an operation amount of an accelerator pedal, and a brake sensor that detects an operation amount of a brake pedal. For example, the vehicle sensor 27 includes a rotation sensor that detects the rotation speed of an engine or a motor, an air pressure sensor that detects the air pressure of a tire, a slip rate sensor that detects the slip rate of a tire, and a wheel speed sensor that detects the rotation speed of a wheel. For example, the vehicle sensor 27 includes a battery sensor that detects a remaining amount and a temperature of a battery, and an impact sensor that detects an external impact.

The storage unit 28 includes at least one of a nonvolatile storage medium or a volatile storage medium, and stores data and a program. The storage unit 28 is used as, for example, an EEPROM (Electrically Erasable Programmable Read Only Memory) and a RAM (Random Access Memory), and a magnetic storage device such as an HDD (Hard Disc Drive), a semiconductor storage device, an optical storage device, and a magneto-optical storage device can be applied as the storage medium. The storage unit 28 stores various programs and data used by the respective units of the vehicle control system 11. For example, the storage unit 28 includes an EDR (Event Data Recorder) and/or a DSSAD (Data Storage System for Automated Driving), and stores information of the vehicle 1 before and after an event such as an accident and/or information acquired by the in-vehicle sensor 26.

The driving support/driving automation control unit 29 controls driving support and driving automation of the vehicle 1. For example, the driving support/driving automation control unit 29 includes an analysis unit 61, an action planning unit 62, and an operation control unit 63.

The analysis unit 61 performs analysis processing of the vehicle 1 and a situation around the vehicle 1. The analysis unit 61 includes a self-position estimation unit 71, a sensor fusion unit 72, and the recognition unit 73.

The self-position estimation unit 71 estimates the self-position of the vehicle 1 based on sensor data from the external recognition sensor 25 and a high-precision map accumulated in the map information accumulation unit 23. For example, the self-position estimation unit 71 estimates the self-position of the vehicle 1 by generating a local map based on sensor data from the external recognition sensor 25 and matching the local map with the high-precision map. As the position of the vehicle 1, for example, the center of the rear wheel pair axle is used as a reference.

The local map is, for example, a three-dimensional high-precision map created using a technology such as SLAM (Simultaneous Localization and Mapping), an occupancy grid map, and/or the like. The three-dimensional high-precision map is, for example, the above-described point cloud map or the like. The occupancy grid map is a map in which a three-dimensional or two-dimensional space around the vehicle 1 is divided into grids (lattice) of a predetermined size, and an occupancy state of an object is indicated for each grid. The occupancy state of an object is indicated by, for example, the presence or absence or a presence probability of the object. The local map is also used for, for example, detection processing and recognition processing of a situation outside the vehicle 1 by the recognition unit 73.

It is noted that the self-position estimation unit 71 may estimate the self-position of the vehicle 1 based on the position information acquired by the position information acquisition unit 24 and the sensor data from the vehicle sensor 27.

The sensor fusion unit 72 performs sensor fusion processing of combining a plurality of different types of sensor data (for example, image data supplied from the camera 51 and sensor data supplied from the radar 52) to obtain new information. Methods for combining different types of sensor data include integration, fusion, association, and the like.

The recognition unit 73 performs detection processing of detecting a situation outside the vehicle 1 and recognition processing of recognizing a situation outside the vehicle 1.

For example, the recognition unit 73 performs the detection processing and the recognition processing of a situation outside the vehicle 1 based on information from the external recognition sensor 25, information from the self-position estimation unit 71, information from the sensor fusion unit 72, and/or the like.

Specifically, for example, the recognition unit 73 performs the detection processing, the recognition processing, and/or the like of an object around the vehicle 1. The detection processing of an object is, for example, processing of detecting the presence or absence, size, shape, position, movement, and/or the like of an object. The recognition processing of an object is, for example, processing of recognizing an attribute such as a type of an object and/or identifying a specific object. It is noted that the detection processing and the recognition processing may not necessarily be clearly divided, and may be at least partially duplicative.

For example, the recognition unit 73 detects an object around the vehicle 1 by performing clustering to classify a point cloud based on sensor data from the radar 52, the LiDAR 53, and/or the like into clusters of point groups. Therefore, the presence or absence, size, shape, and/or position of an object around the vehicle 1 are/is detected.

For example, the recognition unit 73 detects the movement of an object around the vehicle 1 by performing tracking of following the movement of the clusters of point groups classified by clustering. Therefore, the speed and the traveling direction (movement vector) of the object around the vehicle 1 are detected.

For example, the recognition unit 73 detects or recognizes a vehicle, a person, a bicycle, an obstacle, a structure, a road, a traffic light, a traffic sign, a road sign, and/or the like based on the image data supplied from the camera 51. Further, the recognition unit 73 recognizes the type of an object around the vehicle 1 by performing recognition processing such as semantic segmentation.

For example, the recognition unit 73 can perform recognition processing of traffic rules around the vehicle 1 based on a map accumulated in the map information accumulation unit 23, an estimation result of the self-position by the self-position estimation unit 71, and a recognition result of an object around the vehicle 1 by the recognition unit 73. Through this processing, the recognition unit 73 can recognize the position and state of a traffic light, the contents of a traffic sign and a road sign, the contents of a traffic regulation, a travelable lane, and/or the like.

For example, the recognition unit 73 can perform recognition processing of the environment around the vehicle 1. As the surrounding environment to be recognized by the recognition unit 73, there are the weather, temperature, humidity, brightness, the state of the road surface, and/or the like.

The action planning unit 62 creates an action plan of the vehicle 1. For example, the action planning unit 62 creates an action plan by performing path planning and path following.

It is noted that the path planning (Global path planning) is processing of planning a rough path from the start to the goal. This path planning, which is also referred to as trajectory planning, also includes processing of performing generation of a trajectory (Local path planning) through which the vehicle 1 can safely and smoothly travel in the vicinity of the vehicle 1 along the planned path given the motion characteristics of the vehicle 1.

The path following is processing of planning an operation for safe and accurate traveling on a path planned by the path planning within a planned time. For example, the action planning unit 62 can calculate a target speed and a target angular velocity of the vehicle 1 based on a result of the path following processing.

The operation control unit 63 controls the operation of the vehicle 1 in order to achieve the action plan created by the action planning unit 62.

For example, the operation control unit 63 controls a steering control unit 81, a brake control unit 82, and a drive control unit 83 included in the vehicle control unit 32 to be described later to perform acceleration and deceleration control and direction control such that the vehicle 1 travels on the trajectory calculated by the trajectory planning. For example, the operation control unit 63 performs cooperative control that aims at realizing the ADAS functions such as collision avoidance or impact mitigation, follow-up driving, vehicle speed control, vehicle collision warning, and lane departure warning. For example, the operation control unit 63 performs cooperative control that aims at realizing driving automation in which a vehicle autonomously travels irrespective of an operation of a driver, and/or the like.

The DMS 30 performs authentication processing of the driver, recognition processing of the state of the driver, and/or the like based on sensor data from the in-vehicle sensor 26, input data input to the HMI 31 to be described later, and/or the like. Examples of the state of the driver that may be recognized include physical condition, arousal level, concentration level, fatigue level, line-of-sight direction, drunkenness level, driving operation, posture, and the like.

It is noted that the DMS 30 may perform authentication processing of a person on board other than the driver and recognition processing of the state of the person on board. For example, the DMS 30 may perform recognition processing of a situation inside the vehicle based on sensor data from the in-vehicle sensor 26. Examples of the situation inside the vehicle that may be recognized include temperature, humidity, brightness, odor, and the like.

The HMI 31 receives various types of data, instructions, and the like as input and presents various types of data to the driver and/or the like.

Data input to the HMI 31 will be schematically described. The HMI 31 includes an input device used by a person to input data. The HMI 31 generates an input signal based on the data, instruction, and/or the like input by the input device, and supplies the input signal to the respective units of the vehicle control system 11. The HMI 31 includes, for example, operators such as a touch panel, a button, a switch, and a lever as the input device. The HMI 31 is not limited thereto and may further include an input device that enables inputting information by a method other than manual operation, such as voice, gesture, and/or the like. In addition, the HMI 31 may use, for example, a remote control device that uses infrared rays or radio waves and/or an external connection device adaptive to the operation of the vehicle control system 11, such as a mobile device and a wearable device, as an input device.

Presentation of data by the HMI 31 will be schematically described. The HMI 31 generates visual information, auditory information, and tactile information for the person on board or outside of the vehicle. Furthermore, the HMI 31 performs output control for controlling output, output content, output timing, output method, and/or the like for each piece of generated information. Examples of visual information that may be generated and outputted by the HMI 31 include an operation screen, a state display of the vehicle 1, a warning display, an image such as a monitor image indicating a situation around the vehicle 1, and information indicated by light. An example of auditory information that may be generated and outputted by the HMI 31 is information indicated by sound such as voice guidance, a warning sound, and a warning message. Furthermore, an example of tactile information that may be generated and outputted by the HMI 31 is information given to the tactile sense of the person on board by force, vibration, movement, and/or the like.

As an output device to which the HMI 31 outputs visual information, for example, a display device that presents the visual information by displaying an image by itself and/or a projector device that presents visual information by projecting an image can be applied. It is noted that the display device may be, for example, a device that displays visual information in the field of view of a person on board, such as a head-up display, a transmissive display, or a wearable device having an AR (Augmented Reality) function, in addition to a typical display device including a display. Furthermore, the HMI 31 can also use a display device included in a navigation device, an instrument panel, a CMS (Camera Monitoring System), an electronic mirror, a lamp, and/or the like provided in the vehicle 1, as an output device that outputs visual information.

As an output device to which the HMI 31 outputs auditory information, for example, an audio speaker, a headphone, and/or an earphone can be applied.

As an output device to which the HMI 31 outputs tactile information, for example, a haptic element that uses a haptic technology can be applied. The haptic element is provided, for example, in a portion of the vehicle 1 with which the person on board is in contact, such as a steering wheel or a seat.

The vehicle control unit 32 controls the respective units of the vehicle 1. The vehicle control unit 32 includes the steering control unit 81, the brake control unit 82, the drive control unit 83, a body system control unit 84, a light control unit 85, and a horn control unit 86.

The steering control unit 81 performs detection, control, and/or the like of the state of the steering system of the vehicle 1. The steering system includes, for example, a steering mechanism including a steering wheel and the like, an electric power steering, and/or the like. The steering control unit 81 includes, for example, a steering ECU that controls the steering system, an actuator that drives the steering system, and/or the like.

The brake control unit 82 performs detection, control, and/or the like of the state of the brake system of the vehicle 1. The brake system includes, for example, a brake mechanism including a brake pedal and the like, an ABS (Antilock Brake System), a regenerative brake mechanism, and/or the like. The brake control unit 82 includes, for example, a brake ECU that controls the brake system, an actuator that drives the brake system, and/or the like.

The drive control unit 83 performs detection, control, and/or the like of the state of the drive system of the vehicle 1. The drive system includes, for example, an accelerator pedal, a driving force generation device for generating driving force for an internal combustion engine, a driving motor, or the like, a driving force transmission mechanism for transmitting the driving force to wheels, and/or the like. The drive control unit 83 includes, for example, a drive ECU that controls the drive system, an actuator that drives the drive system, and/or the like.

The body system control unit 84 performs detection, control, and/or the like of the state of the body system of the vehicle 1. The body system includes, for example, a keyless entry system, a smart key system, a power window device, a power seat, an air conditioner, an airbag, a seat belt, a shift lever, and/or the like. The body system control unit 84 includes, for example, a body system ECU that controls the body system, an actuator that drives the body system, and/or the like.

The light control unit 85 performs detection, control, and/or the like of the states of various lights of the vehicle 1. Examples of lights to be controlled include a headlight, a backlight, a fog light, a turn signal, a brake light, a projector light, a display of a bumper, and the like. The light control unit 85 includes a light ECU that controls a light, an actuator that drives the light, and/or the like.

The horn control unit 86 performs detection, control, and/or the like of the state of the car horn of the vehicle 1. The horn control unit 86 includes, for example, a horn ECU that controls the car horn, an actuator that drives the car horn, and/or the like.

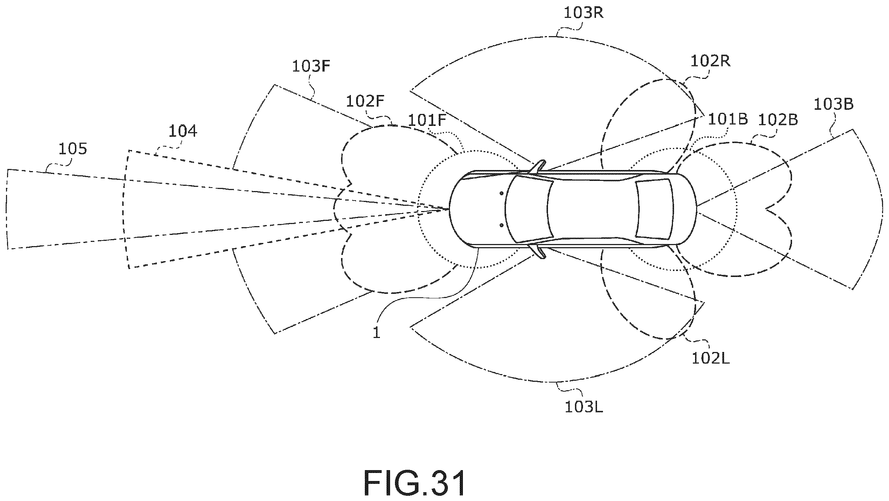

FIG. 31 is a diagram illustrating an example of sensing areas of the camera 51, the radar 52, the LiDAR 53, the ultrasonic sensor 54, and the like of the external recognition sensor 25 in FIG. 30. It is noted that the figure schematically illustrates a state of the vehicle 1 as viewed from above, and the left end side is a front end (front) side of the vehicle 1, and the right end side is a rear end (rear) side of the vehicle 1.

A sensing area 101F and a sensing area 101B indicate examples of the sensing area of the ultrasonic sensor 54. The sensing area 101F covers the periphery of the front end of the vehicle 1 by a plurality of the ultrasonic sensors 54. The sensing area 101B covers the periphery of the rear end of the vehicle 1 by a plurality of the ultrasonic sensors 54.

The sensing results in the sensing area 101F and the sensing area 101B are used, for example, for parking assistance of the vehicle 1, and the like.

Sensing areas 102F to 102B indicate examples of sensing areas of the radar 52 for a short distance or a middle distance. The sensing area 102F covers a position farther than the sensing area 101F in front of the vehicle 1. The sensing area 102B covers a position farther than the sensing area 101B behind the vehicle 1. The sensing area 102L covers the rear periphery of the left side of the vehicle 1. The sensing area 102R covers the rear periphery of the right side of the vehicle 1.

The sensing result in the sensing area 102F is used, for example, for detection or the like of a vehicle, a pedestrian, or the like that is present on the front side of the vehicle 1. The sensing result in the sensing area 102B is used, for example, for a collision prevention function or the like on the rear side of the vehicle 1. The sensing results in the sensing area 102L and the sensing area 102R are used, for example, for detection or the like of an object in blind spots on the sides of the vehicle 1.

Sensing areas 103F to 103B indicate examples of sensing areas of the camera 51. The sensing area 103F covers a position farther than the sensing area 102F in front of the vehicle 1. The sensing area 103B covers a position farther than the sensing area 102B behind the vehicle 1. The sensing area 103L covers the periphery of the left side of the vehicle 1. The sensing area 103R covers the periphery of the right side of the vehicle 1.

The sensing result in the sensing area 103F can be used, for example, for recognition of a traffic light and/or a traffic sign, a lane departure prevention assist system, and/or an automatic headlight control system. The sensing result in the sensing area 103B can be used, for example, for parking assistance and a surround view system. The sensing results in the sensing area 103L and the sensing area 103R can be used, for example, for a surround view system.

A sensing area 104 indicates an example of a sensing area of the LiDAR 53. The sensing area 104 covers a position farther than the sensing area 103F in front of the vehicle 1. On the other hand, the sensing area 104 has a narrower range in the left-right direction than the sensing area 103F.

The sensing result in the sensing area 104 is used, for example, for detecting an object such as a surrounding vehicle.

A sensing area 105 indicates an example of the sensing area of the radar 52 for a long distance.

The sensing area 105 covers a position farther than the sensing area 104 in front of the vehicle 1. On the other hand, the sensing area 105 has a narrower range in the left-right direction than the sensing area 104.

The sensing result in the sensing area 105 is used, for example, for ACC (Adaptive Cruise Control), emergency braking, collision avoidance, and/or the like.

It is noted that the sensing area of each of the camera 51, the radar 52, the LiDAR 53, and the ultrasonic sensor 54 that are included in the external recognition sensor 25 may have various configurations other than those shown in FIG. 31. Specifically, the ultrasonic sensor 54 may also sense the sides of the vehicle 1, and/or the LiDAR 53 may sense the rear of the vehicle 1. Furthermore, the installation position of each sensor is not limited to each example described above. Furthermore, the number of each sensor may be one or more.

It is noted that at least a part of the detection processing and recognition processing of the recognition unit 73 may be executed by the image pickup apparatus 2. For example, a processor (not shown) may be mounted on the connector substrate 500 and/or the imager substrate 700 of the image pickup apparatus 2 so that this processor executes at least a part of the detection processing and recognition processing of the recognition unit 73. Alternatively, another substrate (not shown) that is different from the connector substrate 500 and the imager substrate 700 may be accommodated in the image pickup apparatus 2 so that a processor mounted on this substrate executes at least a part of the detection processing and recognition processing of the recognition unit 73. In this case, for example, the substrate may be provided between the connector substrate 500 and the imager substrate 700. According to the present embodiment, as described above, the internal space of the rear case 100 can be used as efficiently as possible, and the internal space for accommodating the components as the box-type rear chassis 200 can be maximized. Thus, it becomes possible to further accommodate another substrate in the internal space. In addition, by maximizing the internal space, it is possible to accommodate, in the image pickup apparatus 2, further another substrate on which a processor that executes information processing other than the detection processing and recognition processing of the recognition unit 73 is mounted.

The present disclosure may also take the following configurations.
(1) An electronic apparatus, including:
   a substrate unit including an electronic component;
   a first chassis which is formed of a conductive material and includes a box portion that includes a first base portion, first side walls, and second side walls and accommodates the substrate unit, the first side walls and the second side walls being provided in the first base portion and opposing each other in any one of directions orthogonal to a first direction;
   a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surfaces of the first case pressing at least one of the first side walls or the second side walls in at least any one of the directions orthogonal to the first direction;
   a second chassis which is formed of a conductive material and includes a second base portion that opposes the substrate unit in the first direction; and
   a second case which includes a second opening portion that is bonded to the first opening portion, and fixes the first chassis and the second chassis such that the first chassis and the second chassis are electrically connected in a state where the first opening portion and the second opening portion are bonded to each other in the first direction.
(2) The electronic apparatus according to (1), in which
   the first case has a tapered shape that widens from the bottom surface toward the first opening portion, and
   when the first chassis is accommodated in the first case, the first side walls and the second side walls widen from the first base portion along the tapered shape.
(3) The electronic apparatus according to (1) or (2), in which
   the first side walls and the second side walls are at least partially separated from each other when not accommodated in the first case.
(4) The electronic apparatus according to any one of (1) to (3), in which
   one of the first side walls or the second side walls each include one or more convex portions that protrude while opposing in a direction in which the first side walls and the second side walls oppose each other.
(5) The electronic apparatus according to (4), in which
   another one of the first side walls or the second side walls each include one or more receiving holes that engage with the one or more convex portions.
(6) The electronic apparatus according to any one of (1) to (5), in which
   one of the first side walls or the second side walls each include two or more convex portions that protrude while opposing in a direction in which the first side walls and the second side walls oppose each other and are arranged while being separated from each other in the first direction, and
   the one or another one of the first side walls or the second side walls each include one or more slit portions that are provided between the two or more convex portions in the first direction and extend in a direction containing a component of one direction orthogonal to the first direction.
(7) The electronic apparatus according to any one of (1) to (6), in which
   the first chassis includes a pair of first contact members and a pair of second contact members that are provided in the box portion,
   the first case accommodates the first chassis such that the pair of first contact members and the pair of second contact members are exposed from the first opening portion,
   the second chassis includes a pair of third contact members and a pair of fourth contact members that are provided in the base portion, and
   the second case fixes the first chassis and the second chassis such that, in the state where the first opening portion and the second opening portion are bonded to each other in the first direction, the pair of first contact members and the pair of third contact members are electrically connected at two or more first contact points and the pair of second contact members and the pair of fourth contact members are electrically connected at two or more second contact points.
(8) The electronic apparatus according to (7), in which
   the third contact members of the second chassis can bow in a second direction orthogonal to the first direction, and
   in the state where the first opening portion of the first case and the second opening portion of the second case are bonded to each other in the first direction, the second case presses the third contact members of the second chassis against the first contact members of the first chassis in the second direction so that the first contact members and the third contact members are electrically connected at the first contact points.
(9) The electronic apparatus according to (8), in which
   the third contact members of the second chassis can open and close in the second direction by bowing in the second direction,
   the second case presses the third contact members of the second chassis in the second direction to close the third contact members, and
   the first contact members and the third contact members are electrically connected at the first contact points by inserting the first contact members of the first chassis into the third contact members closed by the second case in the first direction so that the third contact members bow in the second direction to nip the first contact members in the second direction.
(10) The electronic apparatus according to (8) or (9), in which
   when the first chassis and the second chassis are fixed by the second case, a thickness of a to-be-nipped portion of each of the first contact members that is a portion to be nipped by the third contact member, in the second direction is larger than a thickness of a non-contact portion of each of the first contact members that is a portion not in contact with the third contact member, in the second direction.
(11) The electronic apparatus according to any one of (7) to (10), in which
   the fourth contact members of the second chassis can bow in the first direction, and
   in the state where the first opening portion of the first case and the second opening portion of the second case are bonded to each other in the first direction, the second contact members of the first chassis and the fourth contact members of the second chassis relatively push each other in the first direction so that the second contact members and the fourth contact members are electrically connected at the second contact points.
(12) The electronic apparatus according to (11), in which
   the second contact members of the first chassis each protrude from a first fulcrum point provided in the box portion in a direction containing a component of a third direction orthogonal to the first direction,
   the fourth contact members of the second chassis each protrude from second fulcrum points provided in the second base portion in the direction containing the component of the third direction,
   a length of the fourth contact members of the second chassis in the third direction is larger than a length of the second contact members of the first chassis in the third direction,
   the second fulcrum points of the second chassis are positioned more on an inner side of the electronic apparatus in the third direction than the first fulcrum point of the first chassis,
   the second contact members of the first chassis are tilted toward the fourth contact members of the second chassis, and
   at the second contact points, a tilt angle of the second contact members of the first chassis with respect to the third direction is larger than a tilt angle of the fourth contact members of the second chassis with respect to the third direction.
(13) The electronic apparatus according to (12), in which
   the fourth contact members of the second chassis include a space portion penetrating in the first direction between the second fulcrum points and the second contact points.
(14) The electronic apparatus according to any one of (7) to (13), in which
   two or more of the second contact members are electrically connected with respect to one of the fourth contact members at the second contact points.
(15) The electronic apparatus according to any one of (7) to (10), in which
   the fourth contact members of the second chassis can bow in a third direction orthogonal to the first direction, and
   in the state where the first opening portion of the first case and the second opening portion of the second case are bonded to each other in the first direction, the second contact members of the first chassis and the fourth contact members of the second chassis relatively push each other in the third direction so that the second contact members and the fourth contact members are electrically connected at the second contact points.
(16) The electronic apparatus according to any one of (7) to (15), in which
   the two or more first contact points and the two or more second contact points are arranged at positions corresponding to four sides of a rectangle when seen in the first direction.
(17) The electronic apparatus according to any one of (1) to (16), in which
   the first chassis is formed of a metal material as the conductive material,
   the second chassis is formed of a metal material as the conductive material, and
   the electrical connection between the first chassis and the second chassis does not include an electrical connection by members other than the first chassis and the second chassis, that are formed of a conductive material.
(18) The electronic apparatus according to any one of (1) to (17), in which
   the electronic component includes an imager device, and
   the electronic apparatus further comprises a lens block which includes a lens retained in the first case or the second case and is optically connected to the imager device while the first direction is set as an optical axis direction.
(19) An image pickup apparatus, including:
   a substrate unit including an electronic component including an imager device;
   a first chassis which is formed of a conductive material and includes a box portion that includes a first base portion, first side walls, and second side walls and accommodates the substrate unit, the first side walls and the second side walls being provided in the first base portion and opposing each other in any one of directions orthogonal to a first direction;
   a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surfaces of the first case pressing at least one of the first side walls or the second side walls in at least any one of the directions orthogonal to the first direction;
   a second chassis which is formed of a conductive material and includes a second base portion that opposes the substrate unit in the first direction;
   a second case which includes a second opening portion that is bonded to the first opening portion, and fixes the first chassis and the second chassis such that the first chassis and the second chassis are electrically connected in a state where the first opening portion and the second opening portion are bonded to each other in the first direction; and
   a lens unit which is retained in the first case or the second case and is optically connected to the imager device while the first direction is set as an optical axis direction.

Although the embodiments and modified examples of the present technology have been described above, the present technology is not limited to only the embodiments described above and can be variously modified without departing from the gist of the present technology.

### Reference Signs List

- 100: rear case

- 1000: lens block
- 1001: front case
- 1002: lens
- 2: image pickup apparatus
- 200: rear chassis
- 3: substrate unit
- 300: radiation block
- 400: radiation sheet
- 500: connector substrate
- 600: substrate holder
- 700: imager substrate
- 800: front chassis
- 900: dustproof sheet

## Claims

1. An electronic apparatus, comprising:
a substrate unit including an electronic component;
a first chassis which is formed of a conductive material and includes a box portion that includes a first base portion, first side walls, and second side walls and accommodates the substrate unit, the first side walls and the second side walls being provided in the first base portion and opposing each other in any one of directions orthogonal to a first direction;
a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surfaces of the first case pressing at least one of the first side walls or the second side walls in at least any one of the directions orthogonal to the first direction;
a second chassis which is formed of a conductive material and includes a second base portion that opposes the substrate unit in the first direction; and
a second case which includes a second opening portion that is bonded to the first opening portion, and fixes the first chassis and the second chassis such that the first chassis and the second chassis are electrically connected in a state where the first opening portion and the second opening portion are bonded to each other in the first direction.

2. The electronic apparatus according to claim **1,** wherein
the first case has a tapered shape that widens from the bottom surface toward the first opening portion, and
when the first chassis is accommodated in the first case, the first side walls and the second side walls widen from the first base portion along the tapered shape.

3. The electronic apparatus according to claim 1, wherein
the first side walls and the second side walls are at least partially separated from each other when not accommodated in the first case.

4. The electronic apparatus according to claim 1, wherein
one of the first side walls or the second side walls each include one or more convex portions that protrude while opposing in a direction in which the first side walls and the second side walls oppose each other.

5. The electronic apparatus according to claim 4, wherein
another one of the first side walls or the second side walls each include one or more receiving holes that engage with the one or more convex portions.

6. The electronic apparatus according to claim 1, wherein
one of the first side walls or the second side walls each include two or more convex portions that protrude while opposing in a direction in which the first side walls and the second side walls oppose each other and are arranged while being separated from each other in the first direction, and
the one or another one of the first side walls or the second side walls each include one or more slit portions that are provided between the two or more convex portions in the first direction and extend in a direction containing a component of one direction orthogonal to the first direction.

7. The electronic apparatus according to claim 1, wherein
the first chassis includes a pair of first contact members and a pair of second contact members that are provided in the box portion,
the first case accommodates the first chassis such that the pair of first contact members and the pair of second contact members are exposed from the first opening portion,
the second chassis includes a pair of third contact members and a pair of fourth contact members that are provided in the base portion, and
the second case fixes the first chassis and the second chassis such that, in the state where the first opening portion and the second opening portion are bonded to each other in the first direction, the pair of first contact members and the pair of third contact members are electrically connected at two or more first contact points and the pair of second contact members and the pair of fourth contact members are electrically connected at two or more second contact points.

8. The electronic apparatus according to claim 7, wherein
the third contact members of the second chassis can bow in a second direction orthogonal to the first direction, and
in the state where the first opening portion of the first case and the second opening portion of the second case are bonded to each other in the first direction, the second case presses the third contact members of the second chassis against the first contact members of the first chassis in the second direction so that the first contact members and the third contact members are electrically connected at the first contact points.

9. The electronic apparatus according to claim 8, wherein
the third contact members of the second chassis can open and close in the second direction by bowing in the second direction,
the second case presses the third contact members of the second chassis in the second direction to close the third contact members, and
the first contact members and the third contact members are electrically connected at the first contact points by inserting the first contact members of the first chassis into the third contact members closed by the second case in the first direction so that the third contact members bow in the second direction to nip the first contact members in the second direction.

10. The electronic apparatus according to claim 8, wherein
when the first chassis and the second chassis are fixed by the second case, a thickness of a to-be-nipped portion of each of the first contact members that is a portion to be nipped by the third contact member, in the second direction is larger than a thickness of a non-contact portion of each of the first contact members that is a portion not in contact with the third contact member, in the second direction.

11. The electronic apparatus according to claim 7, wherein
the fourth contact members of the second chassis can bow in the first direction, and
in the state where the first opening portion of the first case and the second opening portion of the second case are bonded to each other in the first direction, the second contact members of the first chassis and the fourth contact members of the second chassis relatively push each other in the first direction so that the second contact members and the fourth contact members are electrically connected at the second contact points.

12. The electronic apparatus according to claim 11, wherein
the second contact members of the first chassis each protrude from a first fulcrum point provided in the box portion in a direction containing a component of a third direction orthogonal to the first direction,
the fourth contact members of the second chassis each protrude from second fulcrum points provided in the second base portion in the direction containing the component of the third direction,
a length of the fourth contact members of the second chassis in the third direction is larger than a length of the second contact members of the first chassis in the third direction,
the second fulcrum points of the second chassis are positioned more on an inner side of the electronic apparatus in the third direction than the first fulcrum point of the first chassis,
the second contact members of the first chassis are tilted toward the fourth contact members of the second chassis, and
at the second contact points, a tilt angle of the second contact members of the first chassis with respect to the third direction is larger than a tilt angle of the fourth contact members of the second chassis with respect to the third direction.

13. The electronic apparatus according to claim 12, wherein
the fourth contact members of the second chassis include a space portion penetrating in the first direction between the second fulcrum points and the second contact points.

14. The electronic apparatus according to claim 7, wherein
two or more of the second contact members are electrically connected with respect to one of the fourth contact members at the second contact points.

15. The electronic apparatus according to claim 7, wherein
the fourth contact members of the second chassis can bow in a third direction orthogonal to the first direction, and
in the state where the first opening portion of the first case and the second opening portion of the second case are bonded to each other in the first direction, the second contact members of the first chassis and the fourth contact members of the second chassis relatively push each other in the third direction so that the second contact members and the fourth contact members are electrically connected at the second contact points.

16. The electronic apparatus according to claim 7, wherein
the two or more first contact points and the two or more second contact points are arranged at positions corresponding to four sides of a rectangle when seen in the first direction.

17. The electronic apparatus according to claim 1, wherein
the first chassis is formed of a metal material as the conductive material,
the second chassis is formed of a metal material as the conductive material, and
the electrical connection between the first chassis and the second chassis does not include an electrical connection by members other than the first chassis and the second chassis, that are formed of a conductive material.

18. The electronic apparatus according to claim 1, wherein
the electronic component includes an imager device, and
the electronic apparatus further comprises a lens block which includes a lens retained in the first case or the second case and is optically connected to the imager device while the first direction is set as an optical axis direction.

19. An image pickup apparatus, comprising:
a substrate unit including an electronic component including an imager device;
a first chassis which is formed of a conductive material and includes a box portion that includes a first base portion, first side walls, and second side walls and accommodates the substrate unit, the first side walls and the second side walls being provided in the first base portion and opposing each other in any one of directions orthogonal to a first direction;
a first case which includes a bottom surface and a first opening portion that oppose each other in the first direction, accommodates the first chassis such that the first base portion opposes the bottom surface in the first direction, and is put to a state where the first side walls and the second side walls are electrically connected to each other by inner surfaces of the first case pressing at least one of the first side walls or the second side walls in at least any one of the directions orthogonal to the first direction;
a second chassis which is formed of a conductive material and includes a second base portion that opposes the substrate unit in the first direction;
a second case which includes a second opening portion that is bonded to the first opening portion, and fixes the first chassis and the second chassis such that the first chassis and the second chassis are electrically connected in a state where the first opening portion and the second opening portion are bonded to each other in the first direction; and
a lens unit which is retained in the first case or the second case and is optically connected to the imager device while the first direction is set as an optical axis direction.
